(19) **Europäisches Patentamt**
**European Patent Office**
**Office européen des brevets**

(11) **EP 4 451 039 B1**

(12) **EUROPÄISCHE PATENTSCHRIFT**

(45) Veröffentlichungstag und Bekanntmachung des Hinweises auf die Patenterteilung:
**25.03.2026 Patentblatt 2026/13**

(21) Anmeldenummer: **24192101.4**

(22) Anmeldetag: **17.12.2019**

(51) Internationale Patentklassifikation (IPC):
**G01B 11/06** (2006.01) **B29D 11/00** (2006.01)
**C23C 16/52** (2006.01) **G02B 1/115** (2015.01)
**C23C 14/54** (2006.01) **G02B 27/00** (2006.01)

(52) Gemeinsame Patentklassifikation (CPC):
**G01B 11/0616; B29D 11/00865; C23C 14/54;
C23C 16/52; G02B 1/115; G02B 27/0012;
B29D 11/00009**

(54) **SYSTEM VON BESCHICHTUNGSANLAGEN ZUR HERSTELLUNG VON  SCHICHTSYSTEMEN**

SYSTEM OF COATING INSTALLATIONS FOR PRODUCING LAYER SYSTEMS

SYSTÈME D'INSTALLATIONS DE REVÊTEMENT POUR LA FABRICATION DE SYSTÈMES DE COUCHES

(84) Benannte Vertragsstaaten:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorität: **20.12.2018 DE 102018133187**

(43) Veröffentlichungstag der Anmeldung:
**23.10.2024 Patentblatt 2024/43**

(62) Dokumentnummer(n) der früheren Anmeldung(en) nach Art. 76 EPÜ:
**19845695.6 / 3 899 422**

(73) Patentinhaber: **Rodenstock GmbH
80687 München (DE)**

(72) Erfinder:
• **Scherschlicht, Rüdiger
82008 Unterhaching (DE)**

• **Radünz, Stefan
82234 Weßling (DE)**

(74) Vertreter: **Schlotter, Alexander Carolus Paul
Wallinger Ricker Schlotter Tostmann
Patent- und Rechtsanwälte Partnerschaft mbB
Zweibrückenstrasse 5-7
80331 München (DE)**

(56) Entgegenhaltungen:
**EP-A1- 3 346 023       WO-A1-2016/110339
US-A1- 2015 021 168**

• **V. A. KHERAJ ET AL: "Simulation of reflectivity spectrum for non-absorbing multilayer optical thin films", PRAMANA., vol. 72, no. 6, 1 June 2009 (2009-06-01), IN, pages 1011 - 1022, XP055689294, ISSN: 0304-4289, DOI: 10.1007/ s12043-009-0081-0**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

Processed by Luminess, 75001 PARIS (FR)

## Beschreibung

## Stand der Technik

Die Erfindung betrifft ein System von Beschichtungsanlagen zur Herstellung von Schichtsystemen, ein Verfahren zur Herstellung eines Schichtsystems in wenigstens einer Beschichtungsanlage und ein Computer-Programm-Produkt für ein Verfahren zum Betreiben wenigstens einer Beschichtungsanlage.

Ein in einem Fertigungsumfeld implementiertes Beschichtungsverfahren mit einem zugrundeliegenden Beschichtungsprozess weist üblicherweise Abweichungen von Beschichtungscharge zu Beschichtungscharge auf. Diese Abweichungen rühren daher, dass sich der Zustand der Beschichtungsanlage geringfügig verändert, beispielsweise durch Ablagerungen von Beschichtungsmaterial an den Wänden der Vakuumkammer, Bedienereinflüsse bei der Bestückung der Beschichtungsanlage mit Beschichtungsmaterial, Abnutzung diverser in der Beschichtungsanlage verbauten Komponenten und dergleichen.

Ein wirtschaftlich sinnvolles Verfahren, um die Abweichungen von Beschichtungscharge zu Beschichtungscharge möglichst gering zu halten, ist eine sehr genaue Prozesspflege, bei der der zugrundeliegende Beschichtungsprozess von Beschichtungscharge zu Beschichtungscharge gegebenenfalls geringfügig angepasst wird.

Eine solche Prozesspflege setzt ein tiefgreifendes Knowhow voraus und kann bisher nur von gut ausgebildeten Bedienern oder Fachkräften erfolgreich durchgeführt werden.

Im Falle der Beschichtung von Substraten mit einem Schichtsystem, wie es beispielsweise in der optischen Industrie typisch ist, sieht die Prozesspflege dabei wie folgt aus: Nach erfolgter Beschichtung eines optischen Substrats mit einem Schichtsystem wird an mindestens einem beschichteten Substrat eine optische Messung vorgenommen, bei der ein spektral aufgelöstes Messsignal aufgezeichnet wird, welches das optische System bestehend aus dem optischen Substrat und dem aufgebrachten Schichtsystem wiedergibt. Im Falle von Antireflexionsbeschichtungen oder Verspiegelungen wird die spektrale Reflexion oder Reflektivität des optischen Systems in einem handelsüblichen Spektrometer bestimmt. Das Ergebnis ist ein zweidimensionaler Datensatz, bestehend aus Datentupeln (zum Beispiel Wellenlänge in Nanometer, Reflexion in %). Dieser aufgenommene Datensatz ("Anlagen-Ist-Datensatz") wird vom Bediener mit einem gleichartig beschaffenen Soll-Datensatz, welcher im Falle von Antireflexionsbeschichtungen oder Verspiegelungen die spektrale Reflexion des Zielsystems beschreibt, verglichen.

Bei nicht zu tolerierenden Abweichungen im spektralen Verlauf oder den spektralen Parametern wie zum Beispiel den Farbwerten $L^*$, $C^*$, $h^*$ (im sogenannten CIELCh-Farbraum) muss der Bediener eine Korrektur an dem zugrundliegenden Beschichtungsprozess vornehmen. Im Regelfall wird der Bediener die im Beschichtungsprozess hinterlegte abzuscheidende physikalische Schichtdicke von mindestens einer Einzellage des Schichtsystems anpassen. Diese Schichtauswahl basiert zumeist auf Erfahrungen oder vorgegebenen Routinen.

Nachdem eine weitere Beschichtungscharge mit diesem Beschichtungsprozess gefertigt wurde, kann der Bediener die Wirksamkeit seiner Prozesspflege durch einen weiteren Vergleich zwischen Ist-Datensatz und Soll-Datensatz ermitteln und muss gegebenenfalls weitere phänomenologische Korrekturen (nicht numerisch generiert) am Beschichtungsprozess vornehmen.

Dieses Verfahren ist häufig ein zeit- und materialaufwändiger iterativer Versuch- und-Irrtum-Prozess, der nur von kundigen Bedienern durchgeführt werden kann. Dieses beschriebene erfahrungsbasierte Vorgehen wird nicht immer sicher zum gewünschten Ergebnis führen. Desweitern führt die erfahrungsgesteuerte Prozesspflege bei gleichen optischen Farbwerten nicht immer zu gleichen Schichtdickenrelationen. Dieses kann dazu führen, dass Schichteigenschaften und Schichtdickenrelationen sich unwissentlich ändern.

Bekannte optische Elemente mit interferometrischer Entspiegelung, wie sie etwa aus der WO 2016/110339 A1 bekannt sind, weisen üblicherweise einen Lichtreflexionsgrad von ungefähr 1% auf, berechnet nach der Norm DIN EN ISO 13666:2013-10. Die Farbe des verbleibenden Restreflexes kann eine starke Variation zeigen, wenn der Betrachtungswinkel geändert wird. Die Variation kann sich über die gesamte visuelle Farbskala erstrecken.

Die US2015/021168 A1 offenbart eine Inline-Abscheidungskontrollvorrichtung sowie ein Beschichtungsverfahren für eine Beschichtungs-anlage mit mehreren Quellen zum Abscheiden von Schichten auf einem Substrat. Abgeschiedene Schichten auf dem Substrat werden beleuchtet, wobei optische Messsignale spektral aufgelöst erfasst werden. Das Messsignal kann Licht enthalten, das an der abgeschiedenen Schicht reflektiert wird und Licht, das durch das Substrat mit der abgeschiedenen Schicht transmittiert wird. Eine Auswerteeinheit bestimmt die Schichtdicken auf der Grundlage des Messsignals. Eine Steuereinrichtung dient der Rückkopplungssteuerung der Abscheidung von Schichten auf der Grundlage der bestimmten Dicken.

Die EP 3 346 023 A1 beschreibt ein Verfahren zur Beschichtung eines Substrats mit mehreren Schichten. Auf einem Testsubstrat wird eine Schicht mit einer programmierten physikalischen Dicke abgeschieden. Eine Design-Datei enthält die physikalische Solldicke und das spektrale Ergebnis für die Schicht. Aus dem Vergleich der programmierten physikalischen Dicke mit der optischen Dicke der aufgebrachten Schicht wird ein Datensatz erzeugt.

Allgemeinen, technischen Hintergrund zur Simulation der Reflektivität von optischen Mehrschichtsystemen offenbaren V. A. Kheraj et al: "Simulation of reflectivity spectrum for non-absorbing multilayer optical films", V. A. Kheraj et al, Pramana, Bd. 72, Nr. 6, 1. Juni 2009 (2009-06-01), Seiten 1011-1022, XP055689294, IN, ISSN: 0304-4289, DOI: 10.1007/s12043-009-0081-0.

Offenbarung der Erfindung

Die Aufgabe der Erfindung ist es, ein System von Beschichtungsanlagen zum wirtschaftlich optimierten Betreiben einer oder mehrerer Beschichtungsanlagen zur Herstellung von Schichtsystemen anzugeben.

Weitere Aufgaben der Erfindung sind, ein Verfahren und ein Computer-Programm-Produkt anzugeben.

Die Aufgaben werden durch die Merkmale der unabhängigen Ansprüche gelöst. Günstige Ausgestaltungen und Vorteile der Erfindung ergeben sich aus den weiteren Ansprüchen, der Beschreibung und der Zeichnung.

Die Erfindung ist insbesondere für die Herstellung optischer Elemente geeignet. Es soll verstanden werden, dass das erfindungsgemäße Verfahren weder auf die Herstellung optischer Elemente und Beschichtungen beschränkt ist, noch auf die Abscheidung von Mehrschichtsystemen. Ebenso kann das Substrat, auf dem das Schichtsystem abgeschieden ist, bei Bedarf transparent sein oder nicht transparent.

Ferner kann die Erfindung für ein Schichtsystem eingesetzt werden, das aus einer Einzellage besteht, die auf einem Substrat abgeschieden ist und die eine Schichtdicke aufweist. Dies schließt nicht aus, dass zwischen Einzellage und Substrat eine Haftvermittlerschicht angeordnet ist und/oder die Einzellage mit einer Schutzschicht bedeckt ist. Die etwaige Haftvermittlerschicht und/oder Schutzschicht haben keinen oder zumindest keinen nennenswerten Einfluss auf die untersuchten Eigenschaften des Schichtsystems mit der einen Einzellage.

Alternativ kann das Schichtsystem aus mehreren Einzellagen gebildet sein, die aufeinander auf einem Substrat abgeschieden sind und bei dem jede Einzellage jeweils eine Schichtdicke aufweist. Die Schichtdicken der jeweiligen Einzellagen können gleich oder voneinander verschieden sein. Auch hier kann zwischen der substratnächsten Einzellage und dem Substrat eine Haftvermittlerschicht angeordnet sein und/oder das Schichtsystem mit einer Schutzschicht bedeckt sein. Die etwaige Haftvermittlerschicht und/oder Schutzschicht haben keinen oder zumindest keinen nennenswerten Einfluss auf die untersuchten Eigenschaften des Schichtsystems mit den mehreren Einzellagen.

Falls nicht anderweitig angegeben, sollen die in dieser Offenbarung verwendeten Begriffe im Sinne der Norm DIN EN ISO 13666:2013-10 (EN ISO 13666:2012 (D/E)) und der DIN EN ISO 11664-4:2012-06 (EN ISO 11664-4:2011) des Deutschen Instituts für Normung e.V. aus dem Jahr 2012 bzw. 2011 verstanden werden.

Der Begriff sichtbares Licht, sichtbare Strahlung bzw. ein sichtbarer Wellenlängenbereich betrifft gemäß Abschnitt 4.2 der Norm DIN EN ISO 13666:2013-10 optische Strahlung, die unmittelbar eine Lichtempfindung beim Menschen hervorzurufen vermag. Sichtbare Strahlung bezieht sich allgemein auf einen Wellenlängenbereich von 400 nm bis 780 nm.

Im Rahmen dieser Offenbarung kann sich sichtbare Strahlung bevorzugt auf einen Wellenlängenbereich von 400 nm bzw. 460 nm bis 700 nm beziehen, entsprechend des Sensitivitätsmaximums des menschlichen Auges. Damit kann gleichzeitig die Designflexibilität für die Auslegung der Filtereigenschaften und Flankensteilheit erhöht werden.

Der Begriff spektraler Reflexionsgrad, Reflexionsgrad oder Reflektivität bezeichnet entsprechend Abschnitt 15.1 der Norm DIN EN ISO 13666:2013-10 das Verhältnis der spektralen Strahlungsleistung, die von dem jeweiligen Material bzw. der Oberfläche oder Beschichtung reflektiert wird, zur auftreffenden Strahlungsleistung für eine bestimmte Wellenlänge ($\lambda$). Im vorliegenden Fall bezieht sich die Reflektivität auf die Reflektivität der gesamten Beschichtung mit ihren mehreren hoch- und niedrigbrechenden Teilschichten und nicht auf die Reflektivität einer einzelnen Teilschicht.

Nach einem ersten Aspekt der Erfindung, der nicht als solcher beansprucht ist, wird ein Verfahren zum Betreiben wenigstens einer Beschichtungsanlage zur Herstellung von Schichtsystemen vorgeschlagen, umfassend

(i) Erfassen wenigstens einer spektralen Messkurve mit Ordinatenwerten und Abszissenwerten als Ist-Messkurve an einem Ist-Schichtsystem, welches aus einer oder mehreren Einzellagen mit jeweils einer Anlagen-Ist-Schichtdicke der jeweiligen Einzellage besteht, wobei die eine oder mehreren Einzellagen nach einem Anlagen-Datensatz der wenigstens einen Beschichtungsanlage hergestellt sind, wobei der Anlagen-Datensatz wenigstens die Anlagen-Ist-Schichtdicke der jeweiligen Einzellage der einen oder mehreren Einzellagen umfasst;

(ii) Zuordnen der Ist-Messkurve des Ist-Schichtsystems nach wenigstens einem Zuordnungskriterium, insbesondere für signifikante spektrale Punkte der Ist-Messkurve, zu einer Soll-Messkurve eines Soll-Datensatzes mit Ordinatenwerten und Abszissenwerten, dem ein Soll-Datensatz-Schichtsystem, gebildet aus einen oder mehreren Einzellagen, zugrunde liegt, wobei der Soll-Datensatz wenigstens eine bekannte Soll-Schichtdicke der jeweiligen Einzellage der einen oder mehreren Einzellagen umfasst;

(iii) Generieren einer Simulations-Ist-Messkurve nach einem iterativen Verfahren durch Variieren wenigstens von einer Simulations-Ist-Schichtdicke der jeweiligen Einzellagen in zumindest einem spektralen Intervall der Ist-Messkurve und Erhalt eines finalen Simulations-Ist-Datensatzes mit wenigstens einer finalen Simulations-Ist-Schichtdicke der jeweiligen Einzellage der einen oder mehreren Einzellagen, durch welche die Ist-Messkurve in der Simulations-Ist-Messkurve zumindest angenähert wird, bis ein Abbruchkriterium erreicht ist;

(iv) Generieren einer Simulations-Soll-Messkurve nach einem iterativen Verfahren durch Variieren wenigstens der Simulations-Soll-Schichtdicke der jeweiligen Einzellage in zumindest einem spektralen Intervall der Soll-Messkurve und Erhalt eines finalen Simulations-Soll-Datensatzes mit wenigstens einer finalen Simulations-Soll-Schichtdicke der jeweiligen Einzellage der einen oder mehreren Einzellagen, durch welche die Soll-Messkurve in der Simulations-Soll-Messkurve zumindest angenähert wird, bis ein Abbruchkriterium erreicht ist, wobei optische Unterschiede zwischen der Ist-Messkurve und der Simulations-Ist-Messkurve korreliert werden, und der Simulations-Ist-Datensatz für eine Rückrechnung der Simulations-Soll-Messkurve zur Soll-Messkurve (92) verwendet wird; sowie

(v) Bereitstellen des finalen Simulations-Soll-Datensatzes für die wenigstens eine Beschichtungsanlage als neuer Anlagen-Datensatz zur Abscheidung eines weiteren Schichtsystems mit wenigstens einer Korrektur-Ist-Schichtdicke als neue Anlagen-Ist-Schichtdicke der jeweiligen Einzellage, welche aus der finalen Simulations-Soll-Schichtdicke der jeweiligen Einzellage der einen oder mehreren Einzellagen mit dem finalen Simulations-Soll-Datensatz bestimmt werden.

Vorteilhaft ermöglicht das erfindungsgemäße Verfahren eine selbststeuernde und rückgekoppelte Betriebsweise von Beschichtungsanlagen.

Günstigerweise kann die Beschichtungsanlage zur Herstellung von Schichtsystemen beispielsweise für optische Elemente eingesetzt werden.

Die signifikanten Punkte der Kurve können vorteilhaft genutzt werden, um zu einer Messkurve des untersuchten Schichtsystems das passende Soll-Design des Schichtsystems zu finden und dann für eine erste Annäherung in Form einer horizontalen und/oder lateralen Verschiebung der Messkurve zu nutzen.

Der Soll-Datensatz mit der Soll-Messkurve enthält die Zieldaten der optimalen Beschichtung. Diese Daten können neben einer spektral aufgelösten optischen Messung noch weitere Zielgrößen, wie beispielsweise im sichtbaren Spektralbereich die Farbwerte L*, C* und h* und/oder definierte berechenbare spektrale Größen wie gemittelte oder gewichtete Transmissions- und/oder Reflexionswerte in einem beliebig zu definierenden Intervall enthalten. Beispiele für spektral berechenbare Größen können der visuelle Bereich wie auch der IR-A/IR-B und/oder UV-A/UV-B-Bereich sein.

Des Weiteren enthält der Soll-Datensatz beschichtungsspezifische, von klein nach groß geschachtelte spektrale Intervalle. Das größtmögliche angegebene Intervall gibt den maximalen spektralen Betrachtungsbereich wieder. Die Anzahl der Intervalle ist frei wählbar. Der Soll-Datensatz enthält charakteristische spektrale Punkte, die das optische Layout der Beschichtung eindeutig fixieren.

Die Ist-Messkurve umfasst wenigstens die Daten der durchgeführten optischen Messung. Der Anlagen-Datensatz umfasst wenigstens die an der Beschichtungsanlage eingestellten Ist-Schichtdicken der mehreren Einzellagen, wenn das Schichtsystem aus mehreren Einzellagen gebildet ist, bzw. die an der Beschichtungsanlage eingestellte Ist-Schichtdicke der einen Einzellage, wenn das Schichtsystem aus nur einer Einzellage gebildet ist.

Die Simulations-Ist-Messkurve umfasst wenigstens eine simulierte spektrale Messkurve, die vorzugsweise eine bestmögliche Übereinstimmung mit der durchgeführten optischen Messung als Ist-Messkurve darstellt.

Der Simulations-Ist-Datensatz umfasst wenigstens die bei dem iterativen Optimierungsverfahren bestimmten eine Simulations-Ist-Schichtdicke einen der Einzellage des Schichtsystems oder die Simulations-Ist-Schichtdicken der mehreren Einzellagen des Schichtsystems.

Die Simulations-Soll-Messkurve umfasst wenigstens eine simulierte spektrale Messkurve, die vorzugsweise eine bestmögliche Übereinstimmung zwischen der Soll-Messkurve und der Simulations-Ist-Messkurve darstellt.

Der Simulations-Soll-Datensatz umfasst wenigstens die bei dem iterativen Optimierungsverfahren bestimmten Simulations-Soll-Schichtdicken der mehreren Einzellagen bzw. die Simulations-Soll-Schichtdicke der einen Einzellage mit der bestmöglichen Übereinstimmung mit der Soll-Messkurve mit Verrechnung über den Simulations-Soll-Datensatz. Die eingestellten einen oder mehreren Simulations-Soll-Schichtdicken dieses Datensatzes stellen günstigerweise die Prozessparameter für die folgende Beschichtungscharge dar.

Dafür umfasst der Simulations-Soll-Datensatz die eingestellten Berechnungsparameter des simulierten Schichtsystems für möglichst ideale Schichten und/oder ideale Prozesse, Materialeigenschaften wie möglichst ideale Brechwerte und möglichst ideale Abscheidebedingungen, sowie Anlagenparameter wie Beschichtungsgeometrie, Schichtdickenkontrolle, etc..

Der Simulations-Soll-Datensatz korreliert zum einen die optischen Unterschiede zwischen der Ist-Messkurve und der Simulations-Ist-Messkurve sowie berücksichtigt dabei systembedingte Abweichungen, wie morphologische und technische Abweichungen von Beschichtungscharge zu Beschichtungscharge, sowie nicht-systembedingte Abweichungen, wie zum Beispiel Handhabungsunterschiede etc.. Zum anderen wird der Simulations-Ist-Datensatz für die Rückrechnung der Simulations-Soll-Messkurve zur Soll-Messkurve verwendet.

Unter Zuhilfenahme dieses Simulations-Soll-Datensatz ergibt sich die Möglichkeit einer weitergehenden Analyse der Zusammenhänge aus Anlagenparametern und Schichtparametern und/oder Schichteigenschaften. Hierzu kann es vorteilhaft sein, auf eine statische relevante Anzahl von Datensätzen zurückzugreifen.

Das erfindungsgemäße Verfahren sieht vor, dass eine Ist-Messkurve eines Schichtsystems, welches auf der Beschichtungsanlage abgeschieden wurde, in die Simulationssoftware eines Simulationsrechners, geladen wird.

Vorteilhaft kann der Beschichtungsprozess für ein Schichtsystem aus dem Aufbringen von einer Einzellage oder mehreren Einzellagen bestehen. Jede Einzellage wird dabei vorzugsweise durch einen Parametersatz beschrieben, der die physikalische oder optische Schichtdicke neben weiteren Parametern wie Abscheiderate, Prozessgasflüsse etc. beinhaltet. Die einen oder mehreren Einzellagen des Beschichtungsprozesses können dabei aus den Materialien $ZrO_2$, $TiO_2$, $Al_2O_3$, $Ta_2O_5$, $Si_3N_4$, $Nd_2O_5$, $Pr_2O_3$, $PrTiO_3$, $La_2O_3$, $Nb_2O_5$, $Y_2O_3$, $Ce_2O_3$, $Dy_2O_5$, $HfO_2$, $SiO_2$, $MgF_2$, $ZrF_4$, $AlF_3$, $Na_3Al_3F_{14}$, $Na_3AlF_6$, Silane und Siloxane sowie beliebigen Mischungen dieser Materialien bestehen. Als Beschichtungsverfahren können alle typischen Verfahren wie PVD, CVD, Sputtern und deren verwandte Prozesse herangezogen werden.

Mit Hilfe der Simulationssoftware werden aus den spektralen Daten der Ist-Messkurve nach einem Zuordnungskriterium beispielsweise signifikante spektrale Punkte, wie Extremwerte der spektralen Daten, ggf. ausgesuchte Punkte wie 1%-Durchgänge, bei denen die Reflexion 1% ist, eine volle Halbwertsbreite eines Peaks in der Messkurve oder dergleichen ermittelt. Es findet ein Vergleich mit den in einer Datenbank hinterlegten Soll-Messkurven anhand der ermittelten spektralen Punkte statt, um eine zur Ist-Messkurve passende Soll-Messkurve zu finden bzw. eine Soll-Messkurve auszuwählen, bei der die Abweichung zur Ist-Messkurve am geringsten ist. In die Simulationssoftware werden demzufolge alle Soll-Messkurven aus der Datenbank geladen und für jede Soll-Messkurve die Übereinstimmung berechnet zwischen den charakteristischen Punkten der Soll-Messkurve mit den jeweiligen Punkten der Ist-Messkurve.

Für alle spektralen Punkte mit den jeweiligen Koordinaten, nämlich Wellenlänge als Abszisse gegen Intensität als Ordinate, wird der Quotient aus der entsprechenden Abszisse der Ist-Messkurve zu der Abszisse der Soll-Messkurve sowie der gemittelte Quotient aus den bestimmten Quotienten gebildet. Diese gemittelten Quotienten werden im Folgenden Skalierungsfaktoren genannt und gelten einheitlich für das gesamte Schichtsystem.

Für jede dieser Skalierungsfaktoren wird ein virtueller spektraler Datensatz erzeugt, der aus der Schichtdicke bei einer Einzellage bzw. den Schichtdicken bei mehreren Einzellagen der Soll-Messkurve multipliziert mit dem entsprechenden Skalierungsfaktor eine erste Annäherung ergibt.

Dadurch wird für das nachfolgende Optimierungsverfahren ein sehr günstiger Ausgangspunkt geschaffen. Dieser Skalierungsfaktor wird in der Datenbank für weitere mögliche Analysen abgelegt.

Ausgehend von der skalierten vorläufigen Schichtdicke der einzelnen Einzellage bzw. von den skalierten vorläufigen Schichtdicken der mehreren Einzellagen des vorherigen Schritts startet ein Optimierungsverfahren in einem eingeschränkten spektralen Intervall. Dieses eingeschränkte spektrale Intervall ist beschichtungsindividuell und in dem zu der Soll-Messkurve zugeordneten Soll-Datensatz hinterlegt als erstes mögliches aus einer Intervall-Liste des Soll-Datensatzes. Im Rahmen dieses Optimierungsverfahrens wird die Schichtdicke der einen Einzellage, falls das Schichtsystem aus einer Einzellage gebildet ist, bzw. werden Schichtdicken der mehreren Einzellagen, falls das Schichtsystem aus mehreren Einzellagen gebildet ist, ermittelt, welche die Ist-Messkurve mit der zugrundenliegenden Simulations-Soll-Messkurve in einer ersten Annäherung beschreiben.

Aus den im vorherigen Schritt gewonnenen Schichtdicke bzw. Schichtdicken als erste Simulations-Ist-Schichtdicken wird für die eine Einzellage bzw. jede der mehreren Einzellagen der Quotient mit den entsprechenden Ist-Schichtdicke bzw. Ist-Schichtdicken, die an der Beschichtungsanlage eingestellt waren, gebildet. Aus dieser Verrechnung ergibt sich der erste vorläufige Simulations-Datensatz. Dieser erste vorläufige Simulations-Datensatz wird mit den im Soll-Datensatz hinterlegten Soll-Schichtdicken auf Plausibilität auf Einzellagen-Niveau abgeglichen. Eine Abweichung von +/- 20% je Einzellagen-Schichtdicke kann akzeptabel sein, da es sich um eine erste grobe Annäherung handelt. Bei größerer Abweichung wird der Prozess ab dem vorherigen Schritt erneut gestartet, diesmal allerdings mit einer Nebenbedingung im Optimierungsverfahren, nämlich dass die Schichtdicke der Einzellage, für welche die Einzellagen-Schichtdicke außerhalb des vorgegebenen Bereiches war, auf diesen Bereich beschränkt wird.

Im Idealfall ist diese Beschränkung nicht notwendig. Falls doch, können aber auch alle Einzellagen in ihrer Schichtdicke entsprechend beschränkt werden.

Nach diesem Schritt steht ein zweiter vorläufiger Satz an einer Schichtdicke für eine Einzellage oder mehreren Schichtdicken für mehrere Einzellagen bereit. Falls keine Beschränkung notwendig war, ist dieser zweite Simulations-Ist-Datensatz identisch zum ersten vorläufigen Simulations-Ist-Datensatz.

Für jedes weitere spektrale Intervall aus der Intervall-Liste des Soll-Datensatzes wird jetzt das Optimierungsverfahren angewandt. Das aktuell laufende Optimierungsverfahren verwendet immer den Satz des Simulations-Ist-Datensatzes des vorherigen Optimierungsverfahrens.

Typischerweise kann ein angepasster Simplex-Algorithmus als Optimierungsverfahren verwendet werden, jedoch können andere bekannte Simulationsverfahren ebenso geeignet sein. Simulationssoftware für derartige Optimierungsverfahren ist von verschiedenen Herstellern kommerziell erhältlich, beispielswiese die kommerzielle Simulationssoftware "Essential MacLeod" oder andere bekannte Simulationssoftware beispielsweise für die Herstellung optischer Schichten.

Wenn alle Intervall-Iterationen durchgelaufen sind, sind die spektralen Daten der Ist-Messkurve in guter Übereinstimmung angenähert und es liegt eine erste finale Simulations-Ist-Messkurve sowie auch ein entsprechender Satz von Simulations-Ist-Schichtdicken vor. Diese beiden Parametersätze bilden den Simulations-Ist-Datensatz, der zwischengespeichert wird.

Diese Schritte werden so oft wiederholt, bis ein Abbruchkriterium erreicht ist, beispielsweise bis sich nach einem statistischen Auswahlverfahren ein stabiles Ergebnis ergibt. Vorzugsweise kann hierzu die gesamte Kurve betrachtet werden, insbesondere z.B. hinsichtlich Chi-Quadrat Abweichungen und dergleichen.

Wenn die spektralen Daten der Ist-Messkurve in bestmöglicher Übereinstimmung angenähert sind, kann mit den einen oder mehreren Simulations-Ist-Schichtdicken der finale Simulations-Ist-Datensatz generiert werden.

Jetzt wird der Optimierungsprozess erneut gestartet, mit dem Unterschied, dass jetzt die Optimierung zwischen der Simulations-Ist-Messkurve und der Soll-Messkurve stattfindet, um die spektralen Daten des Soll-Datensatzes nachzustellen. Außerdem ist der Simulations-Ist-Datensatz jetzt festgeschrieben und wird nicht mehr verändert.

Am Ende dieser Prozedur liegen eine, falls des Schichtsystem mit einer Einzellage gebildet ist, oder mehrere, falls das Schichtsystem mit mehreren Einzellagen gebildet ist, Simulations-Soll-Schichtdicken vor, welche den Simulations-Soll-Datensatz generieren. Aus diesen einen oder mehreren Simulations-Soll-Schichtdicken werden durch Verrechnung mit dem Simulations-Soll-Datensatz die eine oder mehrere Korrektur-Ist-Schichtdicken als die nächsten einen oder mehreren Anlagen-Ist-Schichtdicken berechnet, welche an der Beschichtungsanlage eingestellt bzw. übermittelt werden.

Vorteile der Erfindung liegen darin, dass im Gegensatz zum im Stand der Technik dargestellten Vorgehen mit dem erfindungsgemäßen Verfahren eine übergreifende analytische Steuerung des Beschichtungsprozesses stattfinden kann, welche vollkommen auf numerischen Berechnungen beruht.

Optional können mit dem erfindungsgemäßen Verfahren nicht nur Schichtdicken berücksichtigt und korrigiert werden, sondern durch Überwachung es können bei Bedarf auch weitere Prozessparameter überwacht werden, beispielsweise Zustand einer Anlage, Alter und/oder Zustand von Beschichtungsquellen, Alter und/oder Zustand von Messapparaturen in den Beschichtungsanlagen, Beladezustand mit Substraten bei der Beschichtung und dergleichen.

Das erfindungsgemäße Verfahren lässt sich für die automatische Selbstoptimierung eines bestehenden Beschichtungsprozesses anwenden sowie auch für die automatische Selbstkonfiguration von neuen Beschichtungsprozessen, wie auch beispielsweise dem Einfahren von Beschichtungsanlagen, anwenden. Unter Einfahren versteht der Fachmann die Neuinstallation bzw. erste Konfiguration eines neuen Beschichtungsprozesses und Beschichtungssystems auf einer Beschichtungsanlage.

Durch die kontinuierliche Optimierung/Überwachung ist sichergestellt, dass die so produzierten Schichtsysteme, beispielsweise optische Elemente, eine möglichst geringe Abweichung von Soll-Daten aufweisen.

Zusätzlich ergeben sich durch neu eingeführte Parametersätze wie Anlagen-Datensätze und Simulationsdatensätze und deren Überwachung neue Möglichkeiten für das Beschichtungs- und Anlagenmonitoring.

Vorteilhaft ergeben sich durch das erfindungsgemäße Verfahren Einsparmöglichkeiten in der Fertigung von Schichtsystemen, beispielsweise für optische Elemente. Es kann eine unmittelbare Reaktion / Meldung bei technisch bedingten Prozessdefiziten erfolgen. Beispielsweise kann bei Aggregatsdefekten in der Beschichtungsanlage sofort die darauffolgende Charge gestoppt werden und dadurch eine Fehlcharge verhindert werden. Bei schleichenden Anlagen- oder Prozessfehlern kann eine Dejustierung verhindert werden durch eine unmittelbare und fortlaufende Schichtkorrektur, wobei der anlagenspezifische Korrektur-Parametersatz dies anzeigt

Eine Pflege der Beschichtungsanlage kann vereinfacht werden. Individuelle Unterschiede der Prozessführung durch unterschiedliche Personen können vermieden werden. Die beschichtungsseitige Qualitätssicherung kann in diesem selbststeuernden System stattfinden und nicht nachgelagert wie bisher.

Weiter ergeben sich vorteilhaft Einsparmöglichkeiten beim Engineering. Das Einfahren von neuen Prozessen kann ferngesteuert von extern erfolgen. Durch einen neuen eingeführten Parametersatz ergeben sich neue Wege zum Verständnis der bisher ungeklärten Anlagen-, Prozess- und Schichtprobleme.

Gemäß einer vorteilhaften Ausgestaltung des erfindungsgemäßen Verfahrens kann das Abbruchkriterium erreicht sein, wenn wenigstens eine der folgenden Bedingungen erfüllt ist:

(i) es wird für das Zuordnungskriterium ein nach einem statistischen Auswahlverfahren stabiles Ergebnis erreicht;
(ii) eine Abweichung zwischen der Ist-Messkurve und der Simulations-Ist-Messkurve liegt innerhalb eines Toleranzbereichs;

(iii) es wurde eine maximale Zahl von Iterationen durchgeführt.

Vorteilhaft kann ein optimales Ergebnis erreicht werden, wenn für das Zuordnungskriterium ein nach einem statistischen Auswahlverfahren stabiles Ergebnis erreicht wird.

Liegt eine Abweichung zwischen der Ist-Messkurve und der Simulations-Ist-Messkurve innerhalb eines Toleranzbereichs, kann ein zumindest zufriedenstellendes Ergebnis erreicht werden.

Wurde eine maximale Zahl von Iterationen durchgeführt, kann ein Rechenaufwand begrenzt werden.

Gemäß einer vorteilhaften Ausgestaltung des erfindungsgemäßen Verfahrens kann als Startwert der Simulations-Ist-Schichtdicke der jeweiligen Einzellage die Soll-Schichtdicke der jeweiligen Einzellage verwendet werden. Dies ergibt gute Ergebnisse des Verfahrens. Alternativ oder zusätzlich kann als Startwert der Simulations-Soll-Schichtdicke der jeweiligen Einzellage die Simulation-Ist-Schichtdicke der jeweiligen Einzellage verwendet werden. Besonders in Kombination mit der Soll-Schichtdicke als dem Startwert der Simulations-Ist-Schichtdicke der jeweiligen Einzellage können die Ergebnisse des Verfahrens weiter verbessert werden.

Alternativ oder zusätzlich kann als Startwert der Simulations-Soll-Schichtdicke der jeweiligen Einzellage eine vorgegebene Schichtdicke der jeweiligen Einzellage verwendet werden. Dies ist günstig, wenn beispielsweise bereits Erfahrungswerte für eine günstige Schichtdicke vorliegen, oder, wenn mehrere Einzellagen abgeschieden werden sollen, bereits Erfahrungswerte zu günstigen Schichtdicken der Einzellagen vorliegen. Ferner kann mit einem nahezu beliebigen Startwert der Schichtdicken der Einzellagen durch eine entsprechend größere Anzahl an Iterationen ein hinreichend gutes Ergebnis für ein Schichtsystem erreicht werden.

Gemäß einer vorteilhaften Ausgestaltung des erfindungsgemäßen Verfahrens kann das Generieren der Simulations-Ist-Messkurve, bzw. Simulations-Soll-Messkurve, weiterhin umfassen:

Bestimmen eines Skalierungsfaktors als Mittelwert von Quotienten aus Abszissenwerten der Ist-Messkurve, bzw. Simulations-Ist-Messkurve und der Soll-Messkurve für nach dem Zuordnungskriterium bestimmte Abszissenwerte und Skalieren der einen Soll-Schichtdicke, falls das Schichtsystem aus einer Einzellage gebildet ist, oder der mehreren Soll-Schichtdicken, falls das Schichtsystem aus mehreren Einzellagen gebildet ist; bzw. der einen oder mehreren Simulations-Ist-Schichtdicken der einen oder mehreren Einzellagen mit dem Skalierungsfaktor als Startwerte der einen oder mehreren Simulations-Ist-Schichtdicken, bzw. einen oder mehreren Simulations-Soll-Schichtdicken.

Demgemäß wird die Simulation-Ist-Messkurve nach dem erfindungsgemäßen Verfahren aus der Ist-Messkurve und den Soll-Schichtdicken generiert, um Startwerte für die Simulations-Ist-Schichtdicken zu bestimmen, während die Simulations-Soll-Messkurve aus der Simulations-Ist-Messkurve und den Simulations-Ist-Schichtdicken generiert wird, um Startwerte für die Simulations-Soll-Schichtdicken zu bestimmen.

Dadurch wird für das nachfolgende Optimierungsverfahren der bestmögliche Ausgangspunkt geschaffen.

Gemäß einer vorteilhaften Ausgestaltung des erfindungsgemäßen Verfahrens kann das Generieren der Simulations-Ist-Messkurve, bzw. Simulations-Soll-Messkurve, weiterhin umfassen:

wenigstens für das erste Intervall für jede der mehreren Einzellagen, wenn das Schichtsystem mehrere Einzellagen aufweist bzw. für die eine Einzellage, wenn das Schichtsystem nur eine Einzellage aufweist: Bilden eines Quotienten aus der entsprechenden ersten finalen Simulations-Ist-Schichtdicke, bzw. der entsprechenden ersten finalen Simulations-Soll-Schichtdicke und der entsprechenden Anlagen-Ist-Schichtdicke, wobei erste Simulations-Ist-Schichtdicken, bzw. Simulations-Soll-Schichtdicken durch Skalieren der Simulations-Ist-Schichtdicken, bzw. Simulations-Soll-Schichtdicken mit dem Quotienten generiert werden.

Demgemäß werden für das Generieren der Simulations-Ist-Messkurve die Simulations-Ist-Schichtdicken herangezogen, während für das Generieren der Simulations-Soll-Messkurve die Simulations-Soll-Schichtdicken herangezogen werden.

Auf diese Weise können in geeigneter Weise günstige Startwerte für die weitere Optimierung bei der Anpassung von Simulations-Ist-Messkurven, bzw. Simulations-Soll-Messkurven generiert werden.

Gemäß einer vorteilhaften Ausgestaltung des erfindungsgemäßen Verfahrens kann das Generieren der Simulations-Ist-Messkurve, bzw. Simulations-Soll-Messkurve, weiterhin umfassen:

Überprüfen der einzelnen ersten einen Simulations-Ist-Schichtdicke oder mehreren Simulations-Ist-Schichtdicken, bzw. der einen Simulations-Soll-Schichtdicke der jeweiligen Einzellage auf zumindest ein Kriterium, insbesondere eine Plausibilität und/oder eine vorgegebene Abweichung von der jeweiligen Soll-Schichtdicke der Soll-Messkurve, und, sofern das wenigstens eine Kriterium verfehlt wird,

Wiederholen des Variierens der Simulations-Ist-Schichtdicke der jeweiligen Einzellage, bzw. der Simulations-Soll-Schichtdicke der jeweiligen Einzellage und des Bereitstellens von einer ersten finalen Simulations-Ist-Schichtdicke bzw. Simulations-Soll-Schichtdicke der jeweiligen Einzellage sowie des Generierens der ersten Simulations-Ist-Schichtdicke, bzw. Simulations-Soll-Schichtdicke der jeweiligen Einzellage der einen oder mehreren Einzellagen, wobei für die eine Einzellage oder für solche der mehreren Einzellagen, welche das Kriterium verfehlt haben, eine Beschränkung beim Variieren vorgegeben wird, und

Bereitstellen von einer zweiten Simulations-Ist-Schichtdicke, bzw. Simulations-Soll-Schichtdicke der jeweiligen Einzellage der einen oder mehreren Einzellagen.

Demgemäß werden für das Generieren der Simulations-Ist-Messkurve die Simulations-Ist-Schichtdicken herangezogen, während für das Generieren der Simulations-Soll-Messkurve die Simulations-Soll-Schichtdicken herangezogen werden.

Diese Vorgehensweise erleichtert das Eingrenzen der Parameter bei dem Optimierungsverfahren und beschleunigt so das Bestimmen der optimierten Parametersätze.

Gemäß einer vorteilhaften Ausgestaltung kann das erfindungsgemäße Verfahren weiterhin umfassen:

Wiederholen der Schritte in einem oder mehreren weiteren spektralen Intervallen, wobei jedes folgende Intervall das vorausgegangene Intervall einschließt, wobei die zweite Simulations-Ist-Schichtdicke, bzw. Simulations-Soll-Schichtdicke der jeweiligen Einzellage des vorausgegangenen Intervalls im folgenden Intervall als Startwerte eingesetzt werden und

Bereitstellen von einer finalen Simulations-Ist-Schichtdicke, bzw. Simulations-Soll-Schichtdicke der jeweiligen Einzellage der einen oder mehreren Einzellagen.

Demgemäß werden iterative Intervallschachtelungen jeweils getrennt für Simulations-Ist-Schichtdicken und Simulations-Soll-Schichtdicken durchgeführt.

Auf diese Weise kann vorteilhaft eine effektive Annäherung der Simulations-Messkurven an die gemessenen Ist-Messkurven erfolgen, wobei die Anpassungsparameter so sukzessive verfeinert werden können. Das Risiko, dass ein ungünstiges Minimum im Optimierungsprozess bestimmt wird, lässt sich dadurch reduzieren.

Gemäß einer vorteilhaften Ausgestaltung des erfindungsgemäßen Verfahrens kann ein optisches Element hergestellt werden, wobei das optische Element ein Substrat und ein interferometrisch reflexminderndes Schichtsystem auf wenigstens einer Oberfläche des Substrats umfassen,

wobei das Schichtsystem einen Stapel von mindestens vier aufeinander folgenden Schichtpaketen umfasst, wobei jedes Schichtpaket ein Paar von ersten und zweiten Einzellagen umfasst, wobei die ersten Einzellagen eine erste optische Dicke und die zweiten Einzellagen eine zweite, von der ersten optischen Dicke verschiedene optische Dicke aufweisen,

wobei ein Brechungsindex der jeweils substratnäheren ersten Einzellagen größer ist als ein Brechungsindex der jeweils substratferneren zweiten Einzellagen des Stapels,

wobei das Schichtsystem eine Helligkeit, eine Buntheit und einen Bunttonwinkel einer Restreflexfarbe aufweist,

wobei der Betrag einer Änderung des Bunttonwinkels der Restreflexfarbe in einem Intervall eines Betrachtungswinkels mit den Grenzwerten 0° und 30° bezogen auf eine Oberflächennormale auf das Schichtsystem kleiner als der Betrag einer Änderung der Buntheit im Intervall des Betrachtungswinkels ist,

wobei folgende Schritte ausgeführt werden:

- Definieren eines Schichtdesigns, umfassend zumindest ein erstes Material für hochbrechende erste Einzellagen und ein zweites Material für niedrigbrechende zweite Einzellagen, Anzahl gewünschter Schichtpakete mit den Einzellagen, Startwerte der Dicke der Einzellagen;
- Definieren von Ziel-Farbwerten, umfassend Helligkeit, Buntheit und Bunttonwinkel zumindest an Grenzwerten für ein Intervall eines Betrachtungswinkels mit Grenzwerten von 0° und 30°;
- Durchführen eines Optimierungsverfahrens zur Variation der Einzelschichtdicken, bis ein Optimierungsziel erreicht ist.

Vorteilhaft können die Ziel-Farbwerte an den Grenzwerten des Intervalls gleich oder ähnlich gewählt werden.

Insbesondere können maximale Abweichungen für die Bunttonwinkel unterschiedlicher Restreflexfarben vorgegeben werden.

Vorteilhaft kann das Schichtsystem vier oder fünf Schichtpakete aufweisen, Es können auch mehr als fünf Schichtpakete vorgesehen sein.

Die Buntheit kann auch als Farbsättigung bezeichnet werden. Der Bunttonwinkel kann auch als Farbwinkel bezeichnet werden.

Vorteilhaft kann durch Variation der Schichtdicken der Teilschichten ein farbstabiles Schichtsystem bereitgestellt werden, dessen Restreflexfarbe sich auch bei größerer Änderung des Betrachtungswinkels nicht oder nur geringfügig ändert. Günstigerweise kann durch eine geeignete Kombination von Buntheit und Bunttonwinkel über einen großen Betrachtungswinkelbereich eine farbstabile Restreflexfarbe erreicht werden.

Die ersten, substratnäheren Teilschichten der Schichtpakete im Stapel können aus demselben ersten Material gebildet sein. Die zweiten, substratferneren Teilschichten können ebenso aus einem gleichen, vom ersten Material der ersten Teilschichten verschiedenen zweiten Material gebildet sind. Dabei kann vorgesehen sein, dass im substratfernsten Schichtpaket zwischen erster und zweiter Teilschicht eine Funktionsschicht aus einem dritten Material angeordnet ist, die vergleichbare Brechungseigenschaften wie die zweite Teilschicht aufweist. Für Berechnungszwecke kann die Funktionsschicht gegebenenfalls der zweiten Teilschicht zugeordnet werden. Alternativ können die Materialien der ersten Teilschichten im Stapel variieren. Ebenso kann alternativ vorgesehen sein, dass die Materialien, aus denen die zweiten Teilschichten gebildet sind, im Stapel variieren.

Gemäß einer vorteilhaften Ausgestaltung des erfindungsgemäßen Verfahrens kann der Bunttonwinkel im Intervall des Betrachtungswinkels mit den Grenzwerten 0° und 30° sich um höchstens 15° ändern, bevorzugt um höchstens 10° ändern;
und/oder

der Betrag der Änderung des Bunttonwinkels in einem zweiten Intervall eines Betrachtungswinkels von 0° bis zu einem Grenzbetrachtungswinkel mit einem oberen Grenzwert zwischen 30° und 45° bezogen auf die Oberflächennormale auf das Schichtsystem kleiner als der Betrag einer Änderung der Buntheit im zweiten Intervall des Betrachtungswinkels sein und der Betrag der Buntheit beim Grenzbetrachtungswinkel mindestens 2 sein, insbesondere der Bunttonwinkel im zweiten Intervall sich höchstens um 20° ändern, bevorzugt höchstens um 15° ändern; und/oder
der photopische Reflexionsgrad im Intervall des Betrachtungswinkels mit den Grenzwerten 0° und 30° höchstens 1,5%, bevorzugt höchstens 1,2% sein; und/oder
der skotopische Reflexionsgrad im Intervall des Betrachtungswinkels mit den Grenzwerten 0° und 30° höchstens 1,5%, bevorzugt höchstens 1,2% sein.

Der Farbeindruck des Restreflexes des optischen Systems bleibt für einen Beobachter ganz oder nahezu unverändert.

Vorteilhaft ergibt sich eine farbstabile Restreflexfarbe auch bei größerer Variation des Betrachtungswinkels.

Vorteilhaft können die ersten Teilschichten aus einem hochbrechenden Material gebildet sein.

Günstigerweise können die ersten Teilschichten wenigstens aus einer oder mehreren der Verbindungen $Ta_2O_5$, $TiO_2$, $ZrO_2$, $Al_2O_3$, $Nd_2O_5$, $Pr_2O_3$, $PrTiO_3$, $La_2O_3$, $Nb_2O_5$, $Y_2O_3$, $HfO_2$, InSn-Oxid, $Si_3N_4$, MgO, $CeO_2$, ZnS und/oder deren Modifikationen, insbesondere deren andere Oxidationsstufen und/oder Mischungen derselben mit Silanen und/oder Siloxanen aufweisen.

Diese Materialien sind bekannt als Werkstoffe mit hohem klassischem Brechungsindex für den Einsatz bei optischen Elementen, wie beispielsweise zur Beschichtung von Brillengläsern. Die höherbrechenden Teilschichten können jedoch auch $SiO_2$ oder andere niedrigerbrechende Materialien enthalten, solange der Brechungsindex der gesamten Teilschicht größer als 1,6 ist, bevorzugt mindestens 1,7, besonders bevorzugt mindestens 1,8, ganz besonders bevorzugt mindestens 1,9.

Vorteilhaft können die zweiten Teilschichten aus einem niedrigbrechenden Material gebildet sein.

Die niedrigerbrechenden Teilschichten können wenigstens eines der Materialien $MgF_2$, SiO, $SiO_2$, $SiO_2$ mit Zusätzen von Al, Silane, Siloxane in Reinform oder mit deren fluorierten Derivaten, aufweisen. Die niedrigerbrechenden Teilschichten können jedoch auch eine Mischung von $SiO_2$ und $Al_2O_3$ enthalten. Bevorzugt können die niedrigerbrechenden Teilschichten wenigstens 80 Gewichtsprozent $SiO_2$, besonders bevorzugt wenigstens 90 Gewichtsprozent $SiO_2$ enthalten.

Bevorzugt ist der Brechungsindex der niedrigbrechenden Teilschichten höchstens 1,55, bevorzugt höchstens 1,48, besonders bevorzugt höchstens 1,4. Diese Angaben von Brechungsindizes beziehen sich auf Normalbedingungen bei einer Temperatur von 25° C sowie eine Referenzwellenlänge der verwendeten Lichtintensität von 550 nm.

Typische Beispiele für Schichtmaterialien mit unterschiedlichen Brechungsindizes sind Siliziumdioxid ($SiO_2$) mit einem Brechungsindex von 1,46, Aluminiumoxid ($Al_2O_3$) mit einem Brechungsindex von 1,7, Zirkondioxid ($ZrO_2$) mit einem Brechungsindex von 2,05, Praseodym-Titanoxid ($PrTiO_3$) mit einem Brechungsindex von 2,1, Titanoxid ($TiO_2$) und Zinksulfid (ZnS) mit jeweils einem Brechungsindex von 2,3. Diese Werte stellen mittlere Werte dar, die je nach Beschichtungsverfahren und Schichtdicke bis zu 10% variieren können.

Übliche optische Gläser weisen Brechungsindizes zwischen 1,5 und 2,0 auf. Schichtmaterialien mit Brechungsindizes kleiner als 1,5 wie $MgF_2$, $SiO_2$, werden deshalb in Kombination mit optischen Gläsern als niedrig brechende Materialien bezeichnet, Schichtmaterialien mit Brechungsindizes größer als 2,0 wie $ZrO_2$, $PrTiO_3$, $TiO_2$, ZnS werden in Kombination mit optischen Gläsern als hoch brechende Materialien bezeichnet.

Der Unterschied der Brechungsindizes zwischen den hochbrechenden und niedrigbrechenden Materialien der ersten und zweiten Teilschichten beträgt vorzugsweise je nach Beschichtungsverfahren und Schichtdicke mindestens 0,2 bis mindestens 0,5.

Die verwendeten Materialien für diese Art von Beschichtungen sind die typischen Materialien, die in der Optik mittels beispielsweise PVD-Verfahren (PVD = Physical Vapour Deposition (physikalische Gasphasenabscheidung)) oder CVD-Verfahren (CVD = Chemical Vapour Deposition (chemische Gasphasenabscheidung)) auf ein Substrat aufgebracht werden.

Nach einer günstigen Ausgestaltung des optischen Elements können zumindest die ersten Teilschichten aus einem gleichen ersten Material gebildet sind und die zweiten Teilschichten zumindest überwiegend aus einem gleichen zweiten Material gebildet sind.

Optional können die zweiten Teilschichten aus dem gleichen zweiten Material gebildet sein und lediglich im substratfernsten Schichtpaket eine Funktionsschicht zwischen der ersten Teilschicht und der zweiten Teilschicht aufweisen. Die Funktionsschicht kann niedrigbrechend sein und bedarfsweise der zweiten Teilschicht für Berechnungszwecke zugeschlagen werden.

Nach einem weiteren, insbesondere eigenständigen, Aspekt der Erfindung wird ein Beschichtungssystem zur Herstellung eines Schichtsystems, insbesondere mit einem hier beschriebenen Verfahren zum Betreiben wenigstens einer Beschichtungsanlage zur Herstellung von Schichtsystemen und/oder beispielsweise für ein optisches Element, vorgeschlagen, umfassend wenigstens

eine Beschichtungsanlage zum Beschichten eines Substrats mit einem Schichtsystem;

einen Steuerrechner zum Steuern der Beschichtungsanlage und zur Kommunikation mit einem Simulationsrechner;

ein optisches Messgerät zum Bestimmen einer spektral aufgelösten Ist-Messkurve des Schichtsystems;

einen Simulationsrechner, auf dem eine Simulationssoftware zur optischen Berechnung und Optimierung des Schichtsystems installiert ist;

eine Datenbank zur Speicherung von Anlage-Datensätzen;

ein Eingabegerät zur Eingabe und Steuerung des Simulationsrechners und/oder der Beschichtungsanlage.

Das Beschichtungssystem umfasst auf diese Weise alle nötigen Komponenten, welche für ein effektives Einfahren und Betreiben der Beschichtungsanlage gemäß dem erfindungsgemäßen Verfahren wie oben beschrieben benötigt werden.

Dadurch lässt sich das Einfahren einer neuen Beschichtungsanlage mit dem erfindungsgemäßen Verfahren zum Betreiben einer Beschichtungsanlage zur Herstellung eines Schichtsystems effektiver und schneller durchführen. So ergibt sich erhebliches Einsparungspotential bei der Inbetriebnahme der Beschichtungsanlage. Auch kann das Einfahren der Beschichtungsanlage sogar ferngesteuert erfolgen, wodurch sich weiteres Einsparungspotential durch weniger vor Ort benötigtes Bedienungspersonal ergibt.

Die Beschichtungsanlage umfasst beispielsweise eine Vakuumkammer mit zugeordneten Aggregaten zur Beschichtung von Substraten wie verschiedene Beschichtungsquellen, Blenden, Glashalter, Pumpen, etc.

Vorteilhaft kann das Beschichtungssystem unter Verwendung des Verfahrens nach dem ersten Aspekt der Erfindung selbststeuernd und rückgekoppelt betreibbar sein.

Der Steuerrechner der Beschichtungsanlage steuert den Beschichtungsprozess auf der Beschichtungsanlage und übernimmt die Kommunikation mit der Beschichtungsanlage. Zum automatischen Datenaustausch kann dieser Rechner zumindest über eine Netzwerkverbindung verfügen.

In dem optischen Messgerät kann ein spektral aufgelöstes Messsignal aufgezeichnet werden, welches das optische Element bestehend aus dem optischen Substrat und dem aufgebrachten Schichtsystem wiedergibt. Diese sogenannte Ist-Messkurve kann als ein zweidimensionaler Datensatz, bestehend aus Datentupeln, zum Beispiel als Wellenlänge in Nanometer, Reflektivität in %, zur Verfügung gestellt werden. Diese Daten werden als "spektrale Daten" bezeichnet.

Auf dem Simulationsrechner ist die Simulationssoftware installiert.

Die Simulationssoftware ist ein Computerprogramm, welches zumindest den von dem optischen Messgerät erzeugten Datensatz einlesen kann. Weiter kann die Simulationssoftware Datensätze der Beschichtungsanlage einlesen und ausgeben.

Die Software implementiert das beschriebene erfindungsgemäße Verfahren als Steuerungsalgorithmus. Die Software arbeitet mit der Datenbank und liest beispielsweise Soll-Datensätze aus der Datenbank aus, speichert neu berechnete Simulations-Datensätze in der Datenbank ab. Weiter implementiert die Software mindestens einen beliebigen Optimierungs-/Fitalgorithmus, wie er in handelsüblichen Simulationsprogrammen zu finden ist, beispielsweise in "Essential MacLeod".

In der Datenbank sind die gewonnenen Simulations-Soll-Datensätze für jede Beschichtungsanlage und für jeden Beschichtungsprozess abgespeichert und können zu einem späteren Zeitpunkt wiederausgelesen werden. Zusätzlich enthält die Datenbank für alle hinterlegten Beschichtungsprozesse die zugehörigen Soll-Datensätze.

Der bidirektionale Datenaustausch zwischen dem Steuerrechner der Beschichtungsanlage und der Simulationssoftware kann entweder direkt durch die Simulationssoftware und eine bestehende Netzwerkverbindung zum Steuerrechner der Beschichtungsanlage realisiert werden oder es kann eine weitere Software zum Einsatz kommen, welche den Datenaustausch übernimmt und der Simulationssoftware Daten der Beschichtungsanlage bereitstellt sowie in der Gegenrichtung Daten zurück zur Beschichtungsanlage transferiert. Im manuellen Fall findet dieser Datenaustausch durch die Interaktion mit einem Bediener über ein Eingabegerät statt.

Nach einem weiteren, insbesondere eigenständigen, Aspekt der Erfindung wird eine Beschichtungsanlage zur Herstellung eines Schichtsystems, beispielsweise für ein optisches Element und/oder insbesondere mit einem hier beschriebenen Verfahren zum Betreiben wenigstens einer Beschichtungsanlage zur Herstellung von Schichtsystemen bzw. wie vorstehend beschrieben, vorgeschlagen, umfassend eine Komponente zur Anwendung eines künstlichen Alterungsprozesses auf das Schichtsystem.

Zweckmäßigerweise kann das in der Beschichtungsanlage hergestellte Schichtsystem in derselben Anlage auch gleich künstlich gealtert werden, um so eine stationäre Ist-Messkurve bei der Bestimmung der spektralen Eigenschaften des Schichtsystems zu erhalten. Dadurch ergibt sich eine hohe Sicherheit bei der Bestimmung der richtigen Korrektur-Schichtdicken für die neuen Schichtsysteme, da sich die Eigenschaften der Schichtsysteme im Lauf der Zeit auch nicht mehr stark ändern.

Vorteilhaft ermöglicht das Verfahren unter Verwendung des Verfahrens nach dem ersten Aspekt der Erfindung eine selbststeuernde und rückgekoppelte Betriebsweise von Beschichtungsanlagen.

Nach einem weiteren, insbesondere eigenständigen, Aspekt der Erfindung wird eine Beschichtungsanlage zur Herstellung eines Schichtsystems, beispielsweise für ein optisches Element und/oder insbesondere mit einem hier beschriebenen Verfahren zum Betreiben wenigstens einer Beschichtungsanlage zur Herstellung von Schichtsystemen bzw. wie vorstehend beschrieben, vorgeschlagen, umfassend

    ein optisches Messgerät zum Bestimmen einer spektral aufgelösten Ist-Messkurve des Schichtsystems und/oder
    eine Komponente zur Anwendung eines künstlichen Alterungsprozesses auf das Schichtsystem.

Günstigerweise kann ein optisches Messgerät zur in-situ-Bestimmung der spektralen Daten des hergestellten Schichtsystems auch gleich in der Beschichtungsanlage selbst angeordnet sein. So entfallen Unsicherheiten beim Transfer des Schichtsystems aus der Beschichtungsanlage und mögliche nachträgliche Veränderungen des Schichtsystems. So kann die Bestimmung von geeigneten einen (bei einem Schichtsystem mit einer Einzellage) oder mehreren (bei einem Schichtsystem mit mehreren Einzellagen) Korrektur-Schichtdicken unmittelbarer erfolgen. Eine Optimierung der Anlagen-Datensätze für das Beschichtungsverfahren kann so effektiver erfolgen. Vorteilhaft kann auch noch eine Komponente zur künstlichen Alterung des hergestellten Schichtsystems in die Beschichtungsanlage integriert sein. Zweckmäßigerweise kann das in der Beschichtungsanlage hergestellte Schichtsystem so in derselben Anlage auch gleich künstlich gealtert werden, um so eine stationäre Ist-Messkurve bei der Bestimmung der spektralen Eigenschaften des optischen Elements zu erhalten.

Dadurch ergibt sich eine hohe Sicherheit bei der Bestimmung der richtigen einen oder mehreren Korrektur-Schichtdicken für die neuen Schichtsysteme, da sich die Eigenschaften der Schichtsysteme im Lauf der Zeit auch nicht mehr stark ändern.

Vorteilhaft kann die Beschichtungsanlage unter Verwendung des Verfahrens nach dem ersten Aspekt der Erfindung selbststeuernd und rückgekoppelt betreibbar sein.

Nach einem weiteren, insbesondere eigenständigen, Aspekt der Erfindung wird ein System von Beschichtungsanlagen zur Herstellung von Schichtsystemen, beispielsweise für optische Elemente und/oder insbesondere mit einem hier beschriebenen Verfahren zum Betreiben wenigstens einer Beschichtungsanlage zur Herstellung von Schichtsystemen bzw. wie vorstehend beschrieben, vorgeschlagen, umfassend wenigstens

    eine oder mehrere Beschichtungsanlagen zum Beschichten mindestens eines Substrats mit einem Schichtsystem;
    einen oder mehrere Steuerrechner zum Steuern wenigstens einer Beschichtungsanlage und zur Kommunikation mit einem Simulationsrechner,
    ein optisches Messgerät zum Bestimmen einer spektral aufgelösten Ist-Messkurve des Schichtsystems;
    einen Simulationsrechner, auf dem eine Simulationssoftware zur optischen Berechnung und Optimierung des Schichtsystems installiert ist, und welcher mit dem Steuerungsrechner der Beschichtungsanlage kommuniziert;
    eine Datenbank zur Speicherung von Anlage-Datensätzen; sowie
    ein Eingabegerät zur Eingabe und Steuerung des Simulationsrechners und/oder der einen oder mehreren Beschichtungsanlagen.

In einem solchen System von mehreren Beschichtungsanlagen können die verschiedenen Beschichtungsanlagen von einem Simulationsrechner gesteuert werden, wodurch sich erhebliches Einsparungspotential beim Betreiben der Beschichtungsanlagen ergibt. Auch lassen sich so Erkenntnisse und/oder Datensätze, welche an einer Beschichtungsanlage gewonnen werden, auf effektive Weise auf eine andere Beschichtungsanlage übertragen.

Nach einem weiteren, insbesondere eigenständigen, Aspekt der Erfindung wird ein Computer-Programm-Produkt vorgeschlagen für ein Verfahren zum Betreiben wenigstens einer Beschichtungsanlage zur Herstellung von Schichtsystemen, beispielsweise für optische Elemente.

Das Computer-Programm-Produkt kann die Software zum Steuern und Betreiben von Beschichtungsanlagen in modularer Weise zur Verfügung stellen und für unterschiedlichste Datenverarbeitungssysteme zugänglich machen.

Vorteilhaft kann mittels des Computer-Programm-Produkts unter Verwendung des Verfahrens nach dem ersten Aspekt der Erfindung eine Beschichtungsanlage oder ein System von Beschichtungsanlagen selbststeuernd und rückgekoppelt betreibbar sein.

Nach einem weiteren, insbesondere eigenständigen, Aspekt der Erfindung wird ein Datenverarbeitungssystem zur Ausführung eines Datenverarbeitungsprogramms vorgeschlagen, welches computerlesbare Programmbefehle umfasst, um ein Verfahren zum Betreiben wenigstens einer Beschichtungsanlage zur Herstellung von Schichtsystemen, beispielsweise für optische Elemente und/oder insbesondere wie vorstehend beschrieben bzw. ein hier beschriebenes Verfahren zum Betreiben wenigstens einer Beschichtungsanlage zur Herstellung von Schichtsystemen, auszuführen. Das Datenverarbeitungssystem kann in günstiger Weise den Simulationsrechner und die Datenbank, aber auch den Steuerrechner der Beschichtungsanlage umfassen.

Vorteilhaft kann mittels des Datenverarbeitungssystems unter Verwendung des Verfahrens nach dem ersten Aspekt der Erfindung eine Beschichtungsanlage oder ein System von Beschichtungsanlagen selbststeuernd und rückgekoppelt betreibbar sein.

## Zeichnung

Weitere Vorteile ergeben sich aus der folgenden Zeichnungsbeschreibung. In den Figuren sind Ausführungsbeispiele der Erfindung dargestellt. Die Figuren, die Beschreibung und die Ansprüche enthalten zahlreiche Merkmale in Kombination. Der Fachmann wird die Merkmale zweckmäßigerweise auch einzeln betrachten und zu sinnvollen weiteren Kombinationen zusammenfassen.

## Es zeigen beispielhaft:

Fig. 1    ein Blockdiagramm eines Beschichtungssystems nach einem Ausführungsbeispiel der Erfindung;

Fig. 2    ein Ablauf des Verfahrens zum Betreiben wenigstens einer Beschichtungsanlage zur Herstellung von Schichtsystemen für optische Elemente nach einem Ausführungsbeispiel der Erfindung;

Fig. 3    ein Flussdiagramm des erfindungsgemäßen Verfahrens;

Fig. 4    ein detailliertes Flussdiagramm des erfindungsgemäßen Verfahrens;

Fig. 5    ein optisches Element mit einem Schichtsystem aus fünf Schichtpaketen auf einem Substrat nach einem Ausführungsbeispiel der Erfindung;

Fig. 6    Reflektivitätskurven eines erfindungsgemäßen Schichtsystems bei senkrechtem Lichteinfall mit einer Gegenüberstellung einer Ist-Messkurve und einer Soll-Messkurve im Wellenlängenbereich von 280 nm bis 800 nm;

Fig. 7    eine vergrößerte Darstellung der Reflektivitätskurven von Fig. 6;

Fig. 8    Reflektivitätskurven des Schichtsystems bei senkrechtem Lichteinfall mit einer Gegenüberstellung der Soll-Messkurve und einer skalierten Simulations-Soll-Messkurve;

Fig. 9    Reflektivitätskurven des Schichtsystems bei senkrechtem Lichteinfall mit einer Gegenüberstellung der Soll-Messkurve und einer in einem ersten spektralen Intervall von 380 nm bis 580 nm angefitteten Simulations-Soll-Messkurve;

Fig. 10   Reflektivitätskurven des Schichtsystems bei senkrechtem Lichteinfall mit einer Gegenüberstellung der Soll-Messkurve und einer in einem größeren spektralen Intervall von 380 nm bis 780 nm angefitteten Simulations-Soll-Messkurve;

Fig. 11   Reflektivitätskurven des Schichtsystems bei senkrechtem Lichteinfall mit einer Gegenüberstellung der Ist-Messkurve und einer über den gesamten Wellenlängenbereich von 280 nm bis 800 nm angefitteten Simulations-Soll-Messkurve;

Fig. 12   ein Blockdiagramm eines Systems von Beschichtungsanlagen nach einem weiteren Ausführungsbeispiel der Erfindung.

## Ausführungsformen der Erfindung

In den Figuren sind gleichartige oder gleichwirkende Komponenten mit gleichen Bezugszeichen beziffert. Die Figuren zeigen lediglich Beispiele und sind nicht beschränkend zu verstehen.

Im Folgenden verwendete Richtungsterminologie mit Begriffen wie "links", "rechts", "oben", "unten", "davor" "dahinter", "danach" und dergleichen dient lediglich dem besseren Verständnis der Figuren und soll in keinem Fall eine Beschränkung der Allgemeinheit darstellen. Die dargestellten Komponenten und Elemente, deren Auslegung und Verwendung können im Sinne der Überlegungen eines Fachmanns variieren und an die jeweiligen Anwendungen angepasst werden.

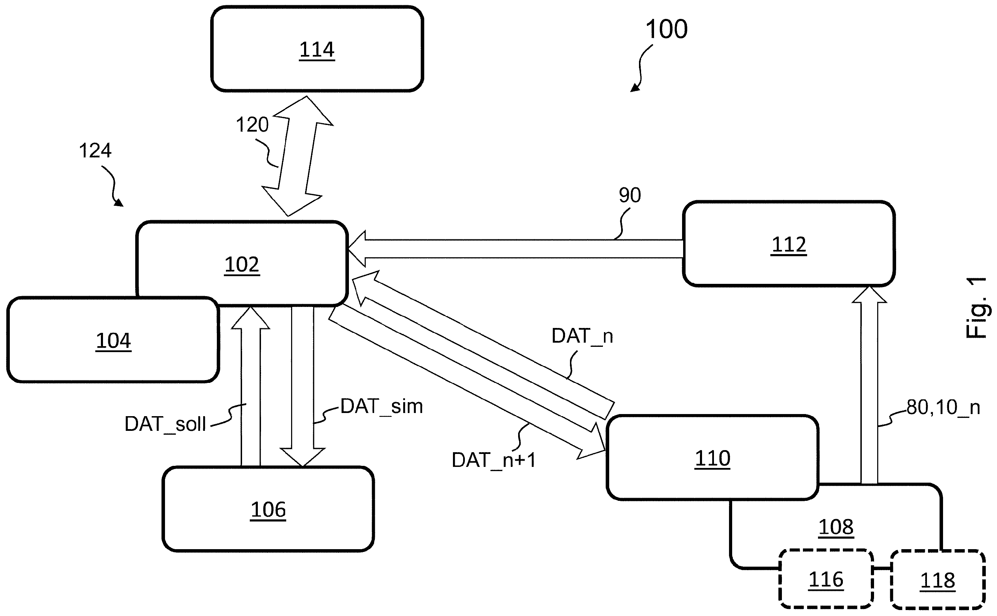

Figur 1 zeigt ein Blockdiagramm eines Beschichtungssystems 100 nach einem Ausführungsbeispiel der Erfindung. Vorteilhaft kann das Beschichtungssystem 100 mit einem selbststeuernden und rückgekoppelten Steuerungsprozess betreibbar sein. Das Beschichtungssystem 100 zur Herstellung eines Schichtsystems 10 für ein optisches Element 80 umfasst wenigstens eine Beschichtungsanlage 108 zum Beschichten eines Substrats 22 mit einem Schichtsystem 10 für ein optisches Element 80.

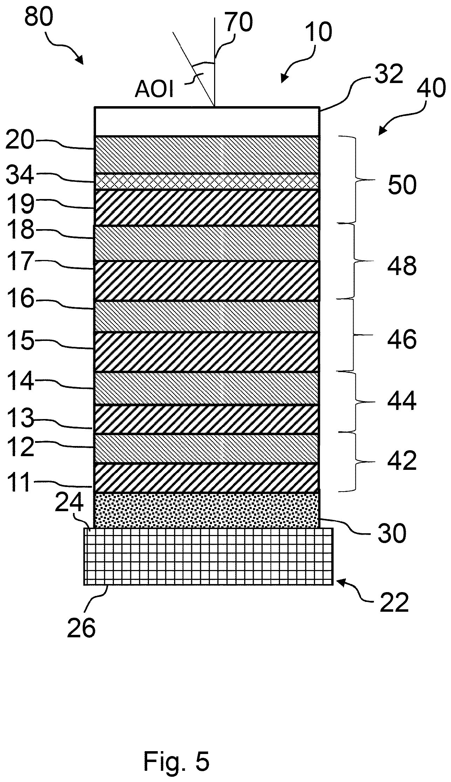

Der Aufbau eines optischen Elements 80 mit einem Schichtsystem 10 auf einem Substrat 22 ist in Figur 5 dargestellt.

Weiter umfasst das Beschichtungssystem 100 einen Steuerrechner 110 zum Steuern der Beschichtungsanlage 108 und zur Kommunikation mit einem Simulationsrechner 102, ein optisches Messgerät zum Bestimmen einer spektral aufgelösten Ist-Messkurve 90 des Schichtsystems 10, einen Simulationsrechner 102, auf dem eine Simulationssoftware 104 zur optischen Berechnung und Optimierung des Schichtsystems 10 installiert ist, eine Datenbank 106 zur Speicherung von Anlage-Datensätzen DAT, sowie ein Eingabegerät 114 zur Eingabe und Steuerung des Simulationsrechners 102 und/oder der Beschichtungsanlage 108 über manuelle Eingaben 120.

Die Datenbank 106 wird vorzugsweise nach einem, insbesondere eigenständigen, Aspekt zur Durchführung eines Verfahrens nach dem ersten Aspekt der Erfindung eingesetzt.

Die Datenbank 106 dient zur Speicherung von Anlage-Datensätzen DAT, für ein Verfahren zum Betreiben der Beschichtungsanlage 108 zur Herstellung von Schichtsystemen 10 für optische Elemente 80, wobei die Anlagen-Datensätze DAT wenigstens Anlagen-Datensätze DAT_n, DAT_n+1, Soll-Datensätze DAT_soll, Simulations-Ist-Datensätze DAT_ist_sim, und/oder Simulations-Soll-Datensätze DAT_soll_sim umfassen.

Auf dem Simulationsrechner 102 ist ein Computer-Programm-Produkt für ein Verfahren nach dem ersten Aspekt der Erfindung zum Betreiben wenigstens einer Beschichtungsanlage 108 zur Herstellung von Schichtsystemen 10 für optische Elemente 80 implementiert, wobei das Computer-Programm-Produkt wenigstens ein computerlesbares Speichermedium umfasst, welches Programmbefehle umfasst, die auf dem Computersystem 102 ausführbar sind und das Computersystem 102 dazu veranlassen, das Verfahren auszuführen.

Das Computer-Programm-Produkt kann als eigenständiger Aspekt der Erfindung angesehen werden, insbesondere zum Ausführen eines Verfahrens nach dem ersten Aspekt der Erfindung auf einem Simulationsrechner 102 eines Datenverarbeitungssystems 124.

Das Datenverarbeitungssystem 124, welches wenigstens den Simulationsrechner 102 und die Simulationssoftware 104 umfasst, dient zur Ausführung eines Datenverarbeitungsprogramms, welches computerlesbare Programmbefehle umfasst, um das Verfahren zum Betreiben der Beschichtungsanlage 108 zur Herstellung von Schichtsystemen 10 für optische Elemente 80, auszuführen.

Das Datenverarbeitungssystem 124 kann als eigenständiger Aspekt der Erfindung angesehen werden, insbesondere zum Ausführen eines Verfahrens nach dem ersten Aspekt der Erfindung mit einem Simulationsrechner 102.

Die Beschichtungsanlage 108 kann optional eine Komponente 116 zur Anwendung eines künstlichen Alterungsprozesses auf das Schichtsystem 10 umfassen, um bei der spektralen Messung des Schichtsystems 10 in dem optischen Messgerät 112, 118 stabile Verhältnisse des optischen Elements 80 sicherzustellen.

In einer weiteren Option kann die Beschichtungsanlage 108 auch ein optisches Messgerät 118 zum Bestimmen einer spektral aufgelösten Ist-Messkurve 90 des Schichtsystems 10 umfassen, sodass in-situ-Messungen der spektralen Eigenschaften des Schichtsystems 10 in der Beschichtungsanlage 108 selbst durchgeführt werden können und ein direktes Feedback an den Simulationsrechner 102 übertragen werden kann.

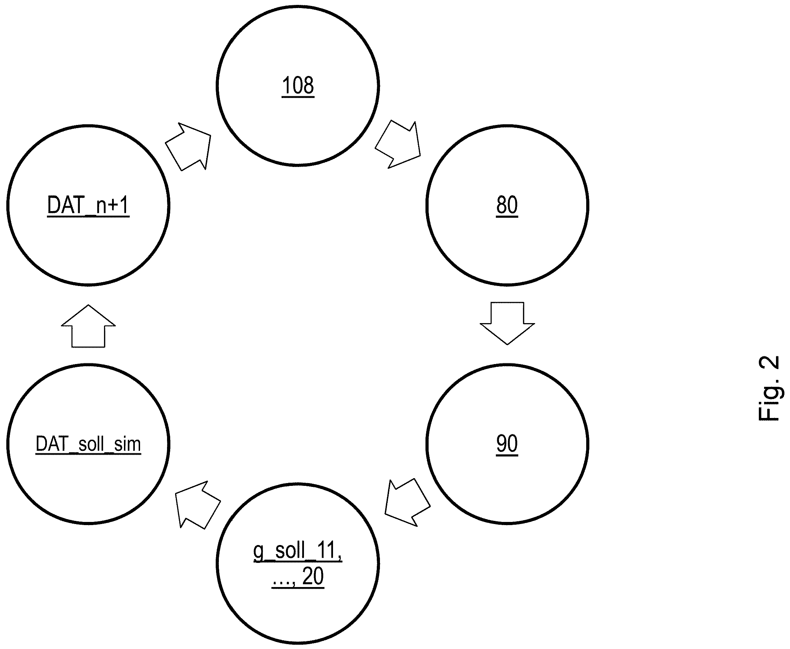

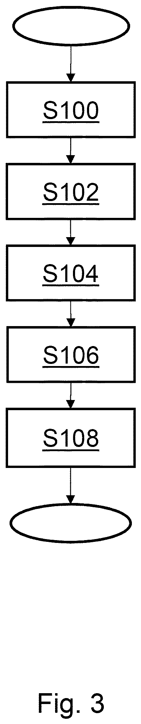

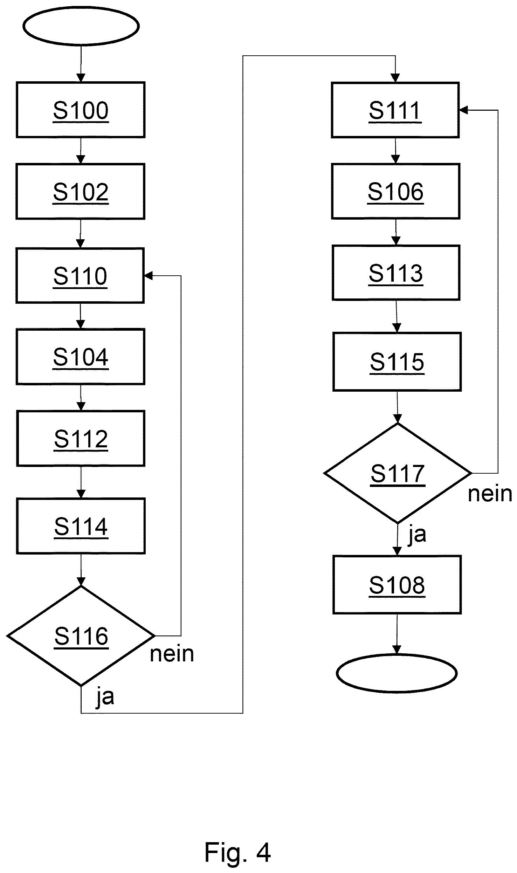

In Figur 2 ist ein Ablauf des Verfahrens nach einem ersten Aspekt der Erfindung zum Betreiben wenigstens einer Beschichtungsanlage 108 zur Herstellung von Schichtsystemen 10 für optische Elemente 80 nach einem Ausführungsbeispiel der Erfindung graphisch dargestellt und in den Figuren 3 und 4 als Flussdiagramm, bzw. als detailliertes Flussdiagramm in einzelnen Schritten beschrieben.

Das Verfahren zum Betreiben der Beschichtungsanlage 108 nach dem ersten Aspekt der Erfindung umfasst im ersten Schritt S100 (i) das Erfassen wenigstens einer spektralen Messkurve mit Ordinatenwerten und Abszissenwerten als Ist-Messkurve 90 an einem Ist-Schichtsystem 10_n, welches aus einer Abfolge von Einzellagen 11, 12, 13, 14, 15, 16, 17, 18, 19, 20 mit jeweiligen Anlagen-Ist-Schichtdicken d_ist_11, ..., d_ist_20 besteht. Die Einzellagen 11, 12, 13, 14, 15, 16, 17, 18, 19, 20 sind dabei nach einem Anlagen-Datensatz DAT_n der Beschichtungsanlage 108 hergestellt. Der Anlagen-Datensatz DAT_n umfasst wenigstens die Anlagen-Ist-Schichtdicken d_ist_11, ..., d_ist_20 der Einzellagen 11, 12, 13, 14, 15, 16, 17, 18, 19, 20.

Im nächsten Schritt S102 geschieht (ii) das Zuordnen der Ist-Messkurve 90 des Ist-Schichtsystems 10_n nach einem Zuordnungs-Kriterium, welches insbesondere signifikante spektrale Punkte der Ist-Messkurve 90 umfassen kann, zu einer Soll-Messkurve 92 eines Soll-Datensatzes DAT_soll mit Ordinatenwerten und Abszissenwerten, dem ein Soll-Datensatz-Schichtsystem 10_soll, gebildet aus Einzellagen 11, 12, 13, 14, 15, 16, 17, 18, 19, 20 zugrunde liegt. Der Soll-Datensatz DAT_soll umfasst dabei wenigstens bekannte Soll-Schichtdicken d_soll_11, ..., d_soll_20 der Einzellagen 11, 12, 13, 14, 15, 16, 17, 18, 19, 20 und kann über den Simulationsrechner 102 aus der Datenbank 106 abgerufen werden.

In einem weiteren Schritt S104 erfolgt (iii) das Generieren einer Simulations-Ist-Messkurve 94 nach einem iterativen Verfahren durch Variieren wenigstens von Simulations-Ist-Schichtdicken g_ist_11, ..., g_ist_20 der Einzellagen 11, 12, 13, 14, 15, 16, 17, 18, 19, 20 in zumindest einem spektralen Intervall 82 der Ist-Messkurve 90. Dabei ergibt sich ein finaler Simulations-Ist-Datensatz DAT_ist_sim mit wenigstens finalen Simulations-Ist-Schichtdicken g_ist_11, ..., g_ist_20, durch welche die Ist-Messkurve 90 in der Simulations-Ist-Messkurve 94 zumindest angenähert wird. Dieses iterative Verfahren wird solange durchgeführt, bis ein Abbruchkriterium erreicht ist, beispielsweise bis für das Zuordnungskriterium ein nach einem statistischen Auswahlverfahren stabiles Ergebnis erreicht ist (Überprüfen S114 und Abfrage S116 in Figur 4). Als Startwerte der Simulations-Ist-Schichtdicken g_ist_11, ..., g_ist_20 werden bei dem iterativen Verfahren beispielsweise die Soll-Schichtdicken d_soll_11, ..., d_soll_20 verwendet.

Im nächsten Schritt S106 erfolgt (iv) das Generieren einer Simulations-Soll-Messkurve 98 nach einem iterativen Verfahren durch Variieren wenigstens der Simulations-Soll-Schichtdicken g_soll_11, ..., g_soll_20 der Einzellagen 11, 12, 13, 14, 15, 16, 17, 18, 19, 20 in zumindest einem spektralen Intervall 82 der Soll-Messkurve 92. Dabei ergibt sich ein finaler Simulations-Soll-Datensatz DAT_soll_sim mit wenigstens finalen Simulations-Soll-Schichtdicken g_soll_11, ..., g_soll_20, durch welche die Soll-Messkurve 92 in der Simulations-Soll-Messkurve 98 zumindest angenähert wird. Dieses iterative Verfahren wird solange durchgeführt, bis ein Abbruchkriterium erreicht ist, beispielsweise bis für das Zuordnungskriterium ein nach einem statistischen Auswahlverfahren stabiles Ergebnis erreicht ist (Überprüfen S115 und Abfrage S117 in Figur 4). Als Startwerte der Simulations-Soll-Schichtdicken g_soll_11, ..., g_soll_20 werden bei dem iterativen Verfahren beispielsweise die Simulation-Ist-Schichtdicken g_ist_11, ..., g_ist_20 verwendet.

In einem letzten Schritt S108 erfolgt (v) das Bereitstellen des finalen Simulations-Soll-Datensatzes DAT_soll_sim für die Beschichtungsanlage 108 als neuer Anlagen-Datensatz DAT_n+1 zur Abscheidung eines weiteren Schichtsystems 10_n+1 mit wenigstens Korrektur-Ist-Schichtdicken d_korr_11, ..., d_korr_20 als neuen Anlagen-Ist-Schichtdicken d_ist_11, ..., d_ist_20. Diese werden aus den finalen Simulations-Soll-Schichtdicken g_soll_11, ..., g_soll_20 mit dem finalen Simulations-Soll-Datensatz DAT_soll_sim bestimmt.

Zum Generieren der Simulations-Ist-Messkurve 94, bzw. Simulations-Soll-Messkurve 98 in den Schritten S104, bzw. S106, kann jeweils in einem Schritt S110, bzw. S111 ein Skalierungsfaktor 122 bestimmt werden als Mittelwert von Quotienten aus Abszissenwerten der Ist-Messkurve 90, bzw. der Simulations-Ist-Messkurve 94 und der Soll-Messkurve 92 für nach dem Zuordnungskriterium bestimmte Abszissenwerte. Mit diesem Skalierungsfaktor 122 werden die Soll-Schichtdicken d_soll_11, ..., d_soll_20; bzw. die Simulations-Ist-Schichtdicken g_ist_11, ..., g_ist_20 der Einzellagen 11, 12, 13, 14, 15, 16, 17, 18, 19, 20 skaliert und als Startwerte der Simulations-Ist-Schichtdicken g_ist_11, ..., g_ist_20, bzw. Simulations-Soll-Schichtdicken g_soll_11, ..., g_soll_20 bestimmt.

Zum Generieren der Simulations-Ist-Messkurve 94, bzw. Simulations-Soll-Messkurve 98 in den Schritten S104, bzw. S106, kann jeweils in einem Schritt S112, bzw. S113, wenigstens für das erste Intervall 82 für jede der Einzellagen 11, 12, 13, 14, 15, 16, 17, 18, 19, 20 ein Quotient 126 aus der entsprechenden ersten finalen Simulations-Ist-Schichtdicke g_ist_11, ..., g_ist_20, bzw. der entsprechenden ersten finalen Simulations-Soll-Schichtdicke g_soll_11, ... , g_soll_20 und der entsprechenden Anlagen-Ist-Schichtdicke d_ist_11, ..., d_ist_20, gebildet werden. Mit dem Quotienten 126 werden erste Simulations-Ist-Schichtdicken g_ist_11, ..., g_ist_20, bzw. Simulations-Soll-Schichtdicken g_soll_11, ..., g_soll_20 durch Skalieren der Simulations-Ist-Schichtdicken g_ist_11, ..., g_ist_20, bzw. Simulations-Soll-Schichtdicken g_soll_11, ..., g_soll_20 mit dem Quotienten 126 generiert.

In einem Schritt S114, bzw. S115 können die einzelnen ersten Simulations-Ist-Schichtdicken g_ist_11, ..., g_ist_20, bzw. Simulations-Soll-Schichtdicken g_soll_11, ..., g_soll_20 auf zumindest ein Kriterium, insbesondere eine Plausibilität und/oder eine vorgegebene Abweichung von den jeweiligen Soll-Schichtdicken g_soll_11, ..., g_soll_20 der Soll-Messkurve 94 überprüft werden. Sofern das wenigstens eine Kriterium verfehlt wird, wird das Variieren der Simulations-Ist-Schichtdicken g_ist_11, ..., g_ist_20, bzw. Simulations-Soll-Schichtdicken g_soll_11, ..., g_soll_20 in den Schritten S104, S106 und das Bereitstellen S108 von ersten finalen Simulations-Ist-Schichtdicken g_ist_11, ..., g_ist_20 bzw. Simulations-Soll-Schichtdicken g_soll_11, ..., g_soll_20 sowie das Generieren der ersten Simulations-Ist-Schichtdicke g_ist_11, ..., g_ist_20, bzw. Simulations-Soll-Schichtdicke g_soll_11, ..., g_soll_20 wiederholt, wobei für solche Einzellagen 11, 12, 13, 14, 15, 16, 17, 18, 19, 20, welche das Kriterium verfehlt haben, eine Beschränkung beim Variieren S104, S106 vorgegeben wird. Anschließen werden die zweiten Simulations-Ist-Schichtdicken g_ist_11, ..., g_ist_20, bzw. Simulations-Soll-Schichtdicken g_soll_11, ..., g_soll_20 bereitgestellt.

Die Schritte S104, S106, S112, S113, S114, S115 können in einem oder mehreren weiteren spektralen Intervallen 84, 86 wiederholt werden, wobei jedes folgende Intervall 84, 86 das vorausgegangene Intervall 82, 84 einschließt, und wobei die zweiten Simulations-Ist-Schichtdicken g_ist_11, ..., g_ist_20, bzw. Simulations-Soll-Schichtdicken g_soll_11, ..., g_soll_20 des vorausgegangenen Intervalls 82, 84 im folgenden Intervall 84, 86 als Startwerte eingesetzt werden und finale Simulations-Ist-Schichtdicken g_ist_11, ..., g_ist_20, bzw. Simulations-Soll-Schichtdicken g_soll_11, ..., g_soll_20 bereitgestellt werden.

Das beschriebene Verfahren zur Herstellung eines Schichtsystems 10 für ein optisches Element 80, kann vorteilhaft so ausgeführt werden, dass das iterative Verfahren für ein oder mehrere spektrale Intervalle 82, 84, 86 durchgeführt wird, wobei jedes folgende Intervall 84, 86 das vorausgegangene Intervall 82, 84 einschließt. Weiter kann das beschriebene Verfahren auch zum Einfahren eines Beschichtungsprozesses in wenigstens einer Beschichtungsanlage 108 zur Herstellung eines Schichtsystems 10 für ein optisches Element 80, benutzt werden.

Die Figur 5 zeigt exemplarisch ein optisches Element 80 mit einem Schichtsystem 10 auf einem Substrat 22, beispielsweise ein Brillenglas, nach einem Ausführungsbeispiel der Erfindung. Das interferometrisch reflexmindernde Schichtsystem 10 ist auf wenigstens einer Oberfläche 24 des Substrats 22 angeordnet. Vorteilhaft ist das Schichtsystem 10 mit einem selbststeuernden und rückgekoppelten Verfahren nach dem ersten Aspekt der Erfindung herstellbar.

Als unterste Lage auf dem Substrat 22 kann das Schichtsystem 10 in üblicher Weise eine einlagige oder mehrlagige Zwischenschicht 30 aufweisen, beispielsweise zur Verbesserung der Haftung des Stapels 40 und/oder als Kratzschutz für das Substrat 22. Diese Zwischenschicht 30 kann in üblicher Weise beispielsweise aus unterstöchiometrischen niederbrechenden Metalloxiden, Chrom, Silanen oder Siloxanen bestehen Die Zwischenschicht 30 ist für die weiteren Betrachtungen der optischen Eigenschaften nicht relevant.

Auf der Zwischenschicht 30 sind in Figur 5 beispielsweise fünf Schichtpakete 42, 44, 46, 48, 50 eines Stapels 40 aufeinander folgend angeordnet.

Auf der Zwischenschicht 30 ist ein Stapel 40 von mindestens vier, in diesem Beispiel fünf, aufeinander folgenden Schichtpaketen 42, 44, 46, 48, 50 angeordnet, wobei jedes Schichtpaket 42, 44, 46, 48, 50 ein Paar von ersten Einzellagen 11, 13, 15, 17, 19 und zweiten Einzellagen 12, 14, 16, 18, 20 umfasst.

Das substratnächste Schichtpaket 42 umfasst die substratnähere Einzellage 11 und die substratfernere Einzellage 12, das nächste Schichtpaket 44 die substratnähere Einzellage 13 und die substratfernere Einzellage 14, das darauffolgende Schichtpaket 46 die substratnähere Einzellage 15 und die substratfernere Einzellage 16, das auf dieses folgende Schichtpaket 48 die substratnähere Einzellage 17 und die substratfernere Einzellage 18 und das substratfernste Schichtpaket 50 die substratnähere Einzellage 19 und die substratfernere Einzellage 20.

Optional kann das substratfernste Schichtpaket 50 zwischen der substratnäheren Teilschicht 19 und der substratferneren Teilschicht 20 eine Funktionsschicht 34 aufweisen, welche beispielsweise zur Erhöhung der elektrischen Leitfähigkeit, zur mechanischen Spannungsegalisierung und/oder als Diffusionssperre wirken kann. Diese Funktionsschicht 34 kann aus einem niedrigbrechenden Material gebildet sein, sowie mit anderen Metalloxiden wie zum Beispiel Aluminium legiert sein. Für Berechnungszwecke und Simulationszwecke der optischen Eigenschaften kann die Funktionsschicht 34 der niedrigerbrechenden Teilschicht 20 des obersten, substratfernsten Schichtpakets 50 zugeschlagen werden oder gegebenenfalls, beispielsweise bei verhältnismäßig geringer Schichtdicke, unberücksichtigt bleiben.

In jedem Schichtpaket 42, 44, 46, 48, 50 weisen die entsprechenden ersten Einzellagen 11, 13, 15, 17, 19 jeweils eine erste optische Dicke t1 und die entsprechenden zweiten Einzellagen 12, 14, 16, 18, 20 jeweils eine zweite, von der ersten optischen Dicke t1 im jeweiligen Schichtpaket 42, 44, 46, 48, 50 verschiedene optische Dicke t2 auf.

Ein Brechungsindex n1 der jeweils substratnäheren ersten Einzellagen 11, 13, 15, 17, 19 ist größer als ein Brechungsindex n2 der jeweils substratferneren zweiten Einzellagen 12, 14, 16, 18, 20 des Stapels 40. Das Schichtsystem 10 weist eine Helligkeit L*, eine Buntheit C* und einen Bunttonwinkel h einer Restreflexfarbe auf, wobei bei der Betrag einer Änderung Δh des Bunttonwinkels h der Restreflexfarbe in einem Intervall eines Betrachtungswinkels AOI mit den Grenzwerten 0° und 30° bezogen auf eine Oberflächennormale 70 auf das Schichtsystem 10 kleiner als der Betrag einer Änderung ΔC* der Buntheit C* im Intervall des Betrachtungswinkels AOI ist.

Betrachtet wird das Schichtsystem von einem Betrachter in einem Betrachtungswinkel AOI von 0° bis zu einem Grenzwinkel, beispielsweise 30°, gemessen von der Oberflächennormalen 70 aus.

Um das Schichtsystem 10 zu entwerfen, werden günstigerweise folgende Schritte durchgeführt:

- Definieren eines Schichtdesigns, umfassend zumindest ein erstes Material für hochbrechende erste Einzellagen 11, 13, 15, 17, 19 und ein zweites Material für niedrigbrechende zweite Einzellagen 12, 14, 16, 18, 20, Anzahl gewünschter Schichtpakete 42, 44, 46, 48, 50 mit den Einzellagen 11, 12, 13, 14, 15, 16, 17, 18, 19, 20, Startwerte der Dicke der Einzellagen 11, 12, 13, 14, 15, 16, 17, 18, 19, 20;
- Definieren von Ziel-Farbwerten, umfassend Helligkeit L*, Buntheit C* und Bunttonwinkel h zumindest an Grenzwerten für ein Intervall eines Betrachtungswinkels AOI mit Grenzwerten von 0° und 30°;
- Durchführen eines Optimierungsverfahrens zur Variation der Einzelschichtdicken d_ist_11, ..., d_ist_20, bis ein Optimierungsziel erreicht ist.

Das Substrat 22 ist beispielsweise ein Kunststoff, insbesondere ein transparenter Kunststoff für ein Brillenglas.

Der Begriff Brillenglas bezeichnet im Rahmen der vorliegenden Offenbarung insbesondere ein beschichtetes Brillenglas gemäß Abschnitt 8.1.13 der Norm DIN EN ISO 13666:2013-10, also ein Brillenglas, auf das eine oder mehrere Oberflächenbeschichtungen aufgebracht wurden, insbesondere um eine oder mehrere seiner Eigenschaften zu ändern.

Bevorzugt können solche Brillengläser insbesondere vorteilhaft eingesetzt werden als Brillen (mit und ohne Korrektur), Sonnenbrillen, Skibrillen, Arbeitsplatzbrillen, sowie Brillen in Verbindung mit kopfgetragenen Anzeigeeinrichtungen (so genannte "head-mounted displays").

Der Begriff Brillenglas kann im Rahmen der vorliegenden Offenbarung ferner Brillenglas-Halbfabrikate umfassen, insbesondere ein Brillenglasblank oder Brillenglas-Halbfertigprodukt gemäß Abschnitt 8.4.2 der Norm DIN EN ISO 13666:2013-10, also einen Linsenrohling oder Blank mit nur einer optischen fertig bearbeiteten Fläche.

Bezogen auf die Ausgestaltungen in Figur 5 kann die gegenüberliegende Oberfläche 26 des Substrats 22 optional ein weiteres, ähnliches oder identisches Schichtsystem 10, keine Beschichtung oder lediglich schützende Beschichtung aufweisen (nicht dargestellt).

Vorzugsweise ist jede der substratnäheren Einzellagen 11, 13, 15, 17, 19 aus einem identischen ersten Material gebildet. Vorzugsweise ist das erste Material ein höherbrechendes Material mit einem ersten Brechungsindex n1.

Vorzugsweise ist jede der substratfernen Einzellagen 12, 14, 16, 18, 20 aus einem identischen zweiten Material gebildet. Vorzugsweise ist das zweite Material ein niedrigbrechendes Material mit einem zweiten Brechungsindex n2. Der Brechungsindex n1 ist größer als der Brechungsindex n2, vorzugsweise ist der Unterschied der Brechungsindizes n1, n2 mindestens 0,2, vorzugsweise bis mindestens 0,5.

Die Reihenfolge der ersten Einzellagen 11, 15, 17, 19 und zweiten Einzellagen 12, 14, 16, 187, 20 bleibt im Stapel 40 gleich, so dass in jedem Schichtpaket 42, 44, 46, 48, 50 die jeweilige substratnähere erste Einzellage 11, 13, 15, 17, 19 immer die höherbrechende und die jeweilige substratfernere zweite Einzellage 12, 14, 16, 18, 20immer die niedrigbrechende der Einzellagen 11, 12, 13, 14, 15, 16, 17, 18, 19, 20 ist.

Insbesondere kann es sich bei den höherbrechenden Einzellagen 11, 13, 15, 17, 19 um Schichten aus hochbrechenden Materialien handeln und bei den niedrigerbrechenden Einzellagen 12, 14, 16, 18, 20 um Schichten aus niedrigbrechenden Materialien.

Die Schichtpakete 42, 44, 46, 48, 50 im Stapel 40 unterscheiden sich nur in ihrer jeweiligen Dicke und/oder in den Dicken der einzelnen Einzellagen 11, 12, 13, 14, 15, 16, 17, 18, 19, 20 im jeweiligen Schichtpaket 42, 44, 46, 48, 50.

Der Stapel 40 ist in an sich bekannter Weise mit einer Deckschicht 32 abgeschlossen, die beispielsweise der Pflege des Schichtsystems 10 dient. Die Deckschicht 32 wird auf die letzte optisch relevante Einzellage 20 des obersten Schichtpakets 50 des Stapels 40 aufgebracht und kann beispielsweise fluorhaltige Moleküle enthalten. Die Deckschicht 32 verleiht dem Stapel 40 üblicherweise eine verbesserte Pflegeeigenschaft, mit Eigenschaften wie eine wasserabweisende und ölabweisende Funktion bei einer Oberflächenenergie von typischerweise kleiner 15 mN/m.

Die Deckschicht 32 ist für die weiteren Betrachtungen der optischen Eigenschaften des Schichtsystems 10 nicht weiter relevant.

Die optischen Eigenschaften des Stapels 40 des Schichtsystems 10 können rechnerisch mittels an sich bekannter Berechnungsverfahren und/oder Optimierungsverfahren simuliert werden. Die Herstellung des Schichtsystems 10 erfolgt sodann mit den bestimmten Schichtdicken der einzelnen Teilschichten 60, 62 der Schichtpakete 42, 44, 46, 48, 50.

Bei der Herstellung von optischen Schichtsystemen 10 werden dessen optische Eigenschaften des Schichtsystems 10 bei der Herstellung der Teilschichten 60, 62 eingestellt. Beispielsweise kann das aus der WO 2016/110339 A1 bekannte Verfahren eingesetzt werden, das im Folgenden kurz umrissen ist. Mit dem bekannten Verfahren können verschiedene optische Effekte wie Verspiegelung oder Reflexminderung in einem Materialsystem erzielt werden, indem nur die Schichtdicken verändert werden, das verwendete Material jedoch gleich bleibt. Es sind jedoch auch andere Verfahren möglich.

Durch eine in der WO 2016/110339 A1 beschriebene Variation der Schichtpaketdicken bei gleichbleibenden Materialien lassen sich unterschiedliche Reflektivitäten, insbesondere für eine reflexmindernde Wirkung erzielen. Dies wird durch Minimierung bzw. Optimierung eines Parameters $\sigma$ erreicht. Der Parameter $\sigma$ ist wiederum eine Funktion der Schichtdicken der Einzellagen 11, 12, 13, 14, 15, 16, 17, 18, 19, 20, bzw. von Verhältnissen der optischen Dicken t1, t2 der Einzellagen 11, 12, 13, 14, 15, 16, 17, 18, 19, 20 eines jeden der vier Schichtpakete 42, 44, 46, 48 (nicht dargestellt) bzw. fünf Schichtpakete 42, 44, 46, 48, 50 nach Figur 5 im Stapel 40.

Bei einer bestimmten Wellenlänge $\lambda$ bestimmt sich die optische Dicke t einer Schicht, auch FWOT (full wave optical thickness) genannt, zu

$$t = \frac{d}{\lambda} \cdot n$$

wobei d die Schichtdicke, $\lambda$ die Auslegungswellenlänge und n den Brechungsindex der Einzellagen 11, 12, 13, 14, 15, 16, 17, 18, 19, 20 darstellt.

Eine reflexmindernde Wirkung durch den Stapel 40 kann für eine vorgebbare Reflektivität $R_m$ des Stapels 40 erreicht werden, wenn das Produkt aus Reflektivität $R_m$ und dem Parameter $\sigma$ kleiner als 1 eingestellt ist:

$$R_m \cdot \sigma < 1$$

Die Reflektivität $R_m$, auch Reflexionsgrad genannt, beschreibt hierbei das Verhältnis von reflektierter zu einfallender Intensität eines Lichtstrahls als Energiegröße. Die Reflektivität $R_m$ wird zweckmäßigerweise über den Bereich des Lichts von 380 nm bis 800 nm gemittelt und auf 100 % bezogen.

Eine solche Bedingung $R_m \cdot \sigma < 1$ kann für einen Optimierungsprozess des Verfahrens zur Herstellung des Schichtsystems 10 als Randbedingung angesetzt werden.

Die optischen Dicken t1, t2 der ersten und zweiten Einzellagen 11, 12, 13, 14, 15, 16, 17, 18, 19, 20 der Schichtpakete 42, 44, 46, 48, 50 werden dadurch bestimmt, dass der Parameter $\sigma$ mittels eines Optimierungsverfahrens, bevorzugt mittels Variationsrechnung, bestimmt wird.

Bevorzugt werden dabei die Dicken der jeweiligen Einzellagen 11, 12, 13, 14, 15, 16, 17, 18, 19, 20 bei fünf Schichtpaketen 42, 44, 46, 48, 50 im Stapel 40 abhängig von einem Quotienten $v_i$ (mit i=1, 2, 3, 4, 5) der ersten optischen Dicke t1 jeweils der höherbrechenden ersten Einzellagen 11, 13, 15, 17, 19 und der zweiten optischen Dicke t2 der niedrigerbrechenden zweiten Einzellagen 12, 14, 16, 18, 20 des jeweiligen Schichtpakets 42, 44, 46, 48, 50 gebildet.

In einer vorteilhaften Ausgestaltung kann bei einem Schichtsystem 10 nach Figur 5 der Parameter σ für einen Stapel 40 mit fünf aufeinander folgenden Schichtpaketen 42, 44, 46, 48, 50 aus der Beziehung

$$\sigma = \frac{v_1}{\sum_{i=2}^{nmax} v_i}$$

bestimmt werden, wobei, i= von 2 bis nmax=5 läuft.

Die Indizes i=1, 2, 3, 4, 5 stehen für die Reihenfolge der Schichtpakete 42, 44, 46, 48, 50 auf dem Substrat 22. Entsprechend stehen $v_1$ für das substratnächste Schichtpaket 42 und $v_5$ für das substratfernste Schichtpaket 50.

Es ist bekannt, wahrnehmungsbezogene Farben im so genannten CIE-L*a*b* Farbraum (vereinfacht CIELab-Farbraum) in kartesischen Koordinaten anzugeben, wie in der DIN EN ISO 11664-4:2012-06 (EN ISO 11664-4:2011) dargelegt ist.

L* ist die CIELab-Helligkeit, a*, b* sind die CIELab-Koordinaten, C* die CIELab-Buntheit und $h_{ab}$ der CIELab-Bunttonwinkel.

Die L*-Achse beschreibt die Helligkeit (Luminanz) der Farbe mit Werten von 0 bis 100. Die L*-Achse steht im Nullpunkt senkrecht auf der a*b*-Ebene. Sie kann auch als Neutralgrauachse bezeichnet werden, da zwischen den Endpunkten Schwarz (L*=0) und Weiß (L*=100) alle unbunten Farben (Grautöne) enthalten sind.

Auf der a*-Achse liegen sich Grün und Rot gegenüber, die b*-Achse verläuft zwischen Blau und Gelb. Komplementäre Farbtöne stehen sich jeweils um 180° gegenüber, in ihrer Mitte, d.h. dem Koordinatenursprung a*=0, b*=0, ist Grau.

Die a*-Achse beschreibt den Grünanteil oder Rotanteil einer Farbe, wobei negative Werte für Grün und positive Werte für Rot stehen. Die b*-Achse beschreibt den Blauanteil oder Gelbanteil einer Farbe, wobei negative Werte für Blau und positive Werte für Gelb stehen.

Die a*-Werte reichen von ca. -170 bis +100, die b*-Werte von -100 bis +150, wobei die Maximalwerte nur bei mittlerer Helligkeit bestimmter Farbtöne erreicht werden. Der CIELab-Farbkörper hat im mittleren Helligkeitsbereich seine größte Ausdehnung, diese ist aber je nach Farbbereich unterschiedlich in Höhe und Größe.

Der CIELab-Bunttonwinkel $h_{ab}$ muss zwischen 0° und 90° liegen, wenn sowohl a* und b* positiv sind, zwischen 90° und 180°, wenn b* positiv ist und a* negativ, zwischen 180° und 270°, wenn sowohl a* und b* negativ sind und zwischen 270° und 360°, wenn b* negativ ist und a* positiv.

Beim CIE-L*C*h-Farbraum (vereinfacht CIELCh-Farbraum) sind die kartesischen Koordinaten des CIELab-Farbraums in Polarkoordinaten transformiert. Dabei werden die Zylinderkoordinaten C* (Buntheit, relative Farbsättigung, Entfernung von der L-Achse im Zentrum) und h (Bunttonwinkel, Winkel des Farbtons im CIELab-Farbkreis) angegeben. Die CIELab-Helligkeit L* bleibt dabei unverändert.

Der Bunttonwinkel h ergibt sich aus den a*- und b*-Achsen

$$h = \arctan\left(\frac{b^*}{a^*}\right)$$

Der Bunttonwinkel h steht hier für die Farbe des Restreflexes der reflexmindernden Schichtsystems 10.

Die Buntheit C* ergibt sich zu

$$C^* = \sqrt{(a^*)^2 + (b^*)^2}$$

Die Buntheit C* wird auch als Farbtiefe bezeichnet.

Um die Schichtdicken d_soll_11, ..., d_soll_20 der Einzellagen 11, 12, 13, 14, 15, 16, 17, 18, 19, 20 festzulegen, wird ein Optimierungsverfahren zur Variation der Einzellagendicken d_soll_11, ..., d_soll_20 durchgeführt, bis ein Optimierungsziel erreicht ist. Das Optimierungsverfahren variiert dann so lange die Einzellagendicken d_soll_11, ..., d_soll_20, bis das Optimierungsziel (Farbstabilität) erreicht ist.

Der Bunttonwinkel h kann sich dabei im Intervall des Betrachtungswinkels AOI mit den Grenzwerten 0° und 30° um höchstens 15° ändern, bevorzugt um höchstens 10° ändern. Der Betrag der Änderung Δh des Bunttonwinkels h kann in einem zweiten Intervall eines Betrachtungswinkels AOI von 0° bis zu einem Grenzbetrachtungswinkel Θ mit oberen Grenzwerten 30° und 45° bezogen auf die Oberflächennormale 70 auf das Schichtsystem 10 kleiner als der Betrag einer Änderung ΔC* der Buntheit C* im zweiten Intervall des Betrachtungswinkels AOI sein und der Betrag der Buntheit C* kann beim Grenzbetrachtungswinkel Θ mindestens Θ =2 sein, insbesondere kann der Bunttonwinkel h im zweiten Intervall sich höchstens um 20° ändern, bevorzugt höchstens um 15° ändern.

Der photopische Reflexionsgrad Rv im Intervall des Betrachtungswinkels AOI mit den Grenzwerten 0° und 30° kann vorteilhaft höchstens 1,5%, bevorzugt höchstens 1,2% sein.

Der skotopische Reflexionsgrad Rv' im Intervall des Betrachtungswinkels AOI mit den Grenzwerten 0° und 30° kann vorteilhaft höchstens als 1,5%, bevorzugt höchstens 1,2% sein.

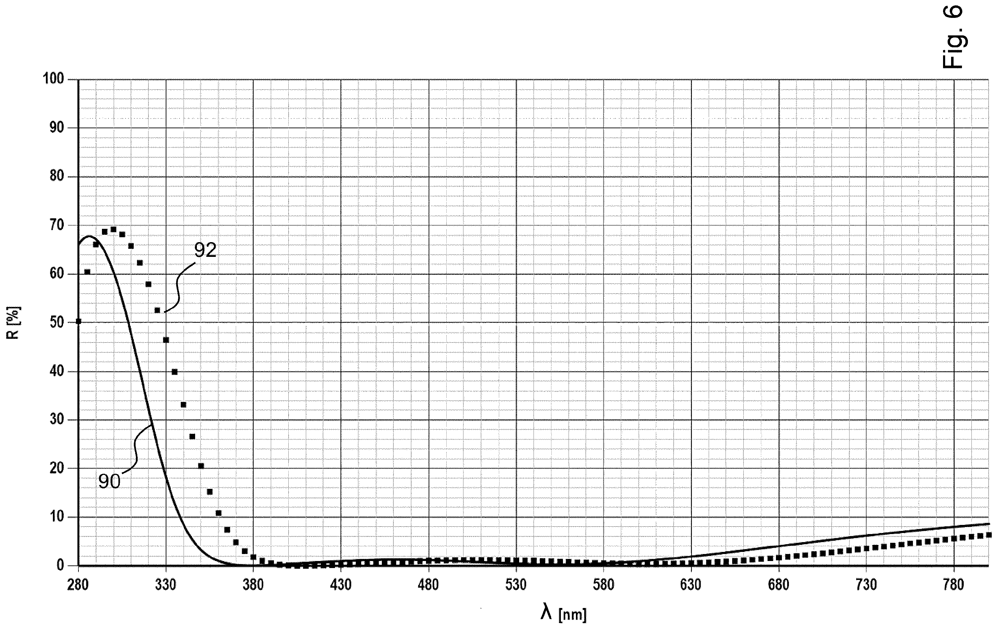

In den Figuren 6 bis 11 sind jeweils Reflektivitätskurven bei senkrechtem Lichteinfall als Ist-Messkurven 90 zusammen mit Soll-Messkurven 92, bzw. Simulations-Ist-Messkurven 94 dargestellt.

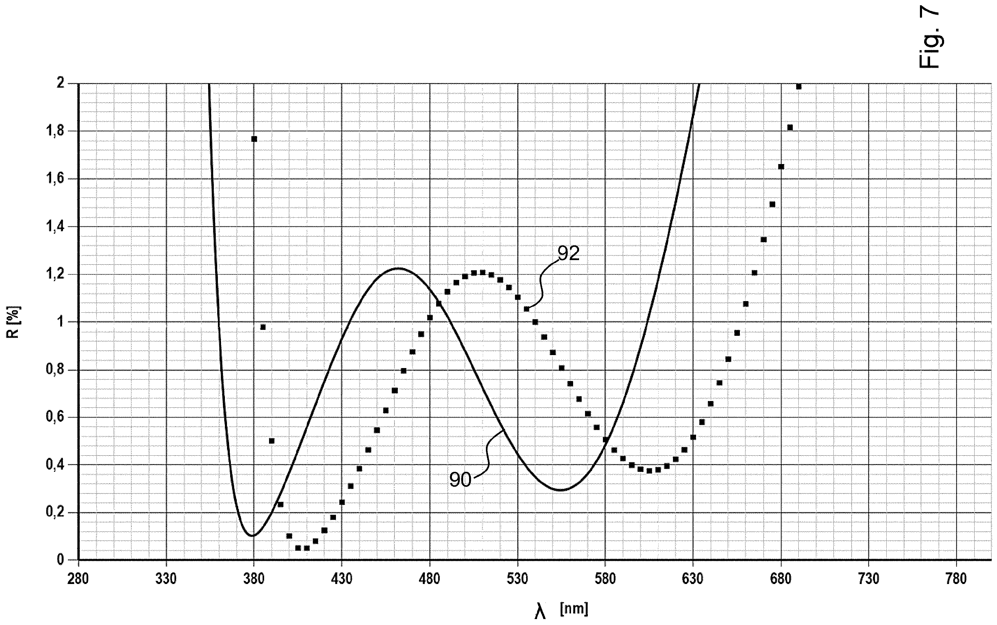

Figur 6 zeigt Reflektivitätskurven eines erfindungsgemäßen Schichtsystems 10 mit einer Gegenüberstellung einer Ist-Messkurve 90 (durchgezogene Linie) und einer Soll-Messkurve 92 (gepunktete Linie) im Wellenlängenbereich von 280 nm bis 800 nm; Figur 7 zeigt eine vergrößerte Darstellung der Reflektivitätskurven von Figur 6. Die Soll-Messkurve 92 wurde dabei mittels Extremwert-Vergleich aus der Datenbank 106 als Soll-Messkurve 92 zur Ist-Messkurve 90 ermittelt. Man erkennt eine starke Peak-Verschiebung im niederen Wellenlängenbereich zwischen 280 nm und 380 nm und in der vergrößerten Darstellung in Figur 7 im Wellenlängenbereich von 380 nm und 680 nm.

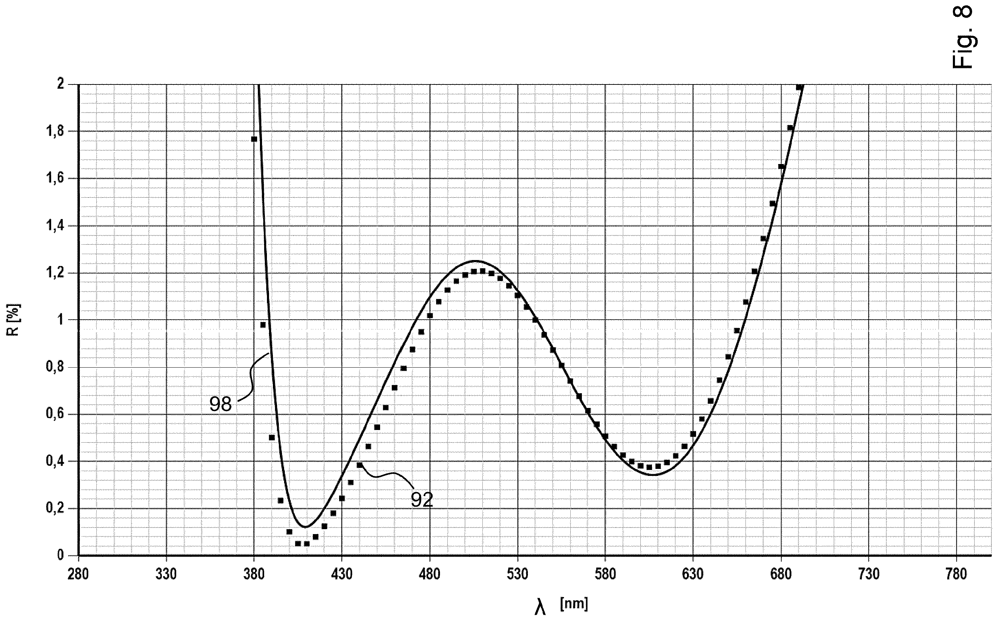

In Figur 8 sind Reflektivitätskurven des Schichtsystems 10 mit einer Gegenüberstellung der Soll-Messkurve 92 (gepunktete Linie) und einer skalierten Simulations-Soll-Messkurve 98 (durchgezogene Linie) dargestellt. Es fand so eine horizontale Verschiebung der Simulations-Soll-Messkurve 98 statt. Das komplette Schichtsystem 10 wurde dabei skaliert, d.h. es wurde der Vektor, der alle physikalischen Schichtdicken g_soll_11, ..., g_soll_20 der das Schichtsystem 10 repräsentierenden Einzelschichten 11, 12, 13, 14, 15, 16, 17, 18, 19, 20 erhält, mit einem Skalierungsfaktor 122 multipliziert, d.h. jede Einzelschicht 11, 12, 13, 14, 15, 16, 17, 18, 19, 20 wurde um den gleichen Skalierungsfaktor 122 dicker bzw. dünner gemacht.

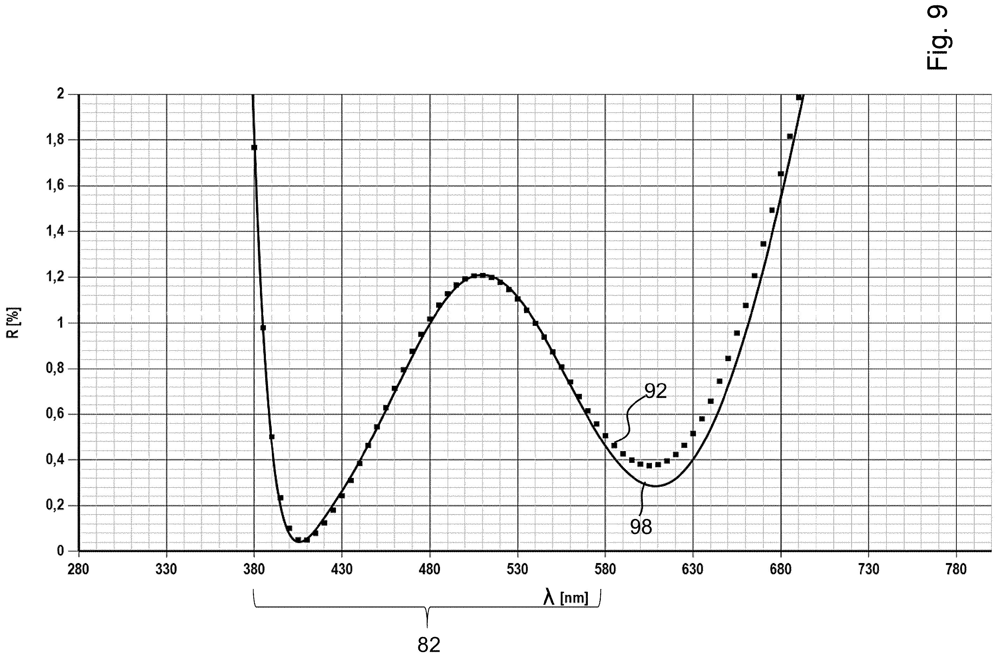

Figur 9 zeigt Reflektivitätskurven des Schichtsystems 10 mit einer Gegenüberstellung der Soll-Messkurve 92 und einer in einem ersten spektralen Intervall 82 von 380 nm bis 580 nm angefitteten Simulations-Soll-Messkurve 98. Dabei wurde für das iterative Optimierungsverfahren der Simplex-Algorithmus angewendet. Der Algorithmus wurde mit dem Optimierungsziel gestartet, die Simulations-Soll-Messkurve 98 aus dem vorherigen Schritt möglichst passgenau auf die Soll-Messkurve 92 im Intervall 380 nm bis 580 nm abzubilden durch Änderung der physikalischen Schichtdicken g_soll_11, ..., g_soll_20. Es ergibt sich eine sehr gute Annäherung der beiden Messkurven 92, 98 in dem gewählten Intervall 82.

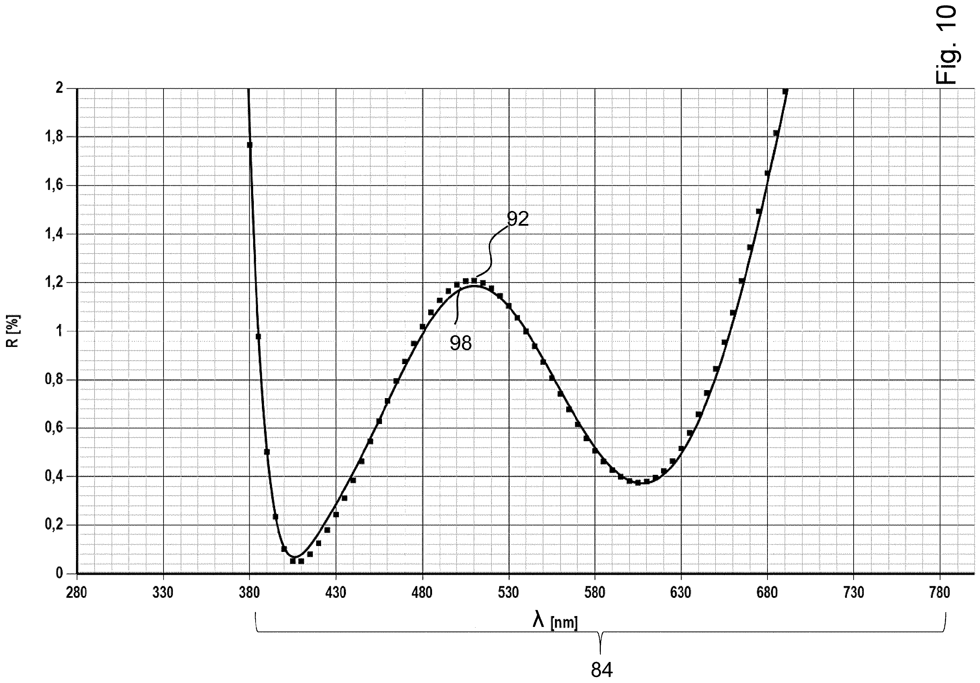

In Figur 10 sind Reflektivitätskurven des Schichtsystems 10 mit einer Gegenüberstellung der Soll-Messkurve 92 und einer in einem größeren spektralen Intervall 84 von 380 nm bis 780 nm angefitteten Simulations-Soll-Messkurve 98 dargestellt. Dieses Mal wurde eine Simplex-Optimierung in dem größeren Intervall 84 von 380 nm bis 780 nm angewandt. Es wurden keine Schichtdickenrelationen berücksichtigt. Im unteren Wellenlängenbereich um 400 nm ist die Qualität der Übereinstimmung der beiden Messkurven 92, 98 geringfügig schlechter, während sie im oberen Wellenlängenbereich von 580 nm bis 680 nm besser ist.

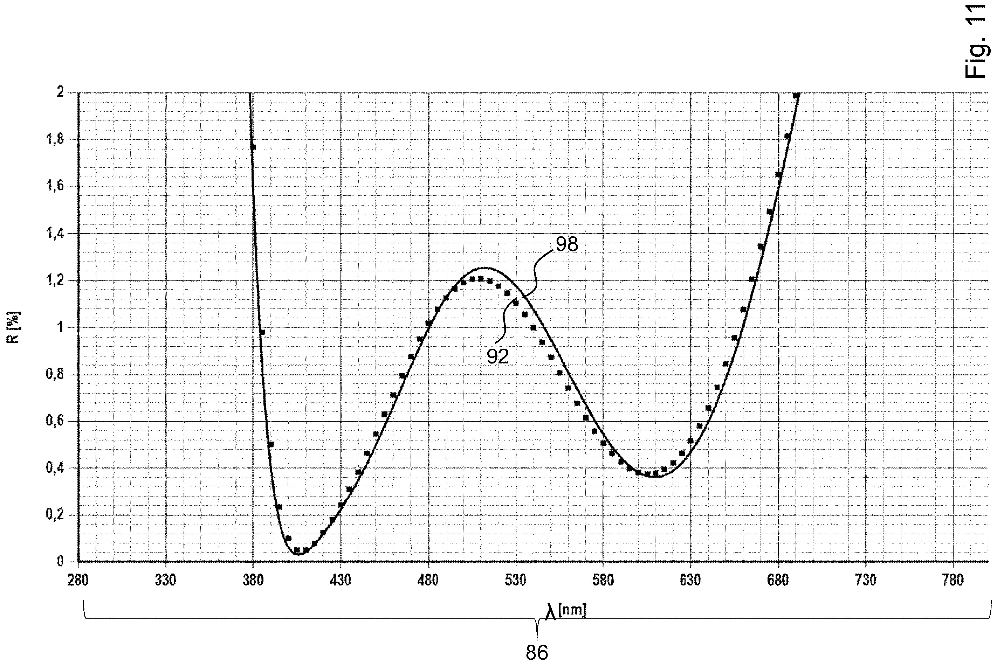

Figur 11 zeigt Reflektivitätskurven des Schichtsystems 10 mit einer Gegenüberstellung der Soll-Messkurve 92 und einer über den gesamten Wellenlängenbereich als Intervall 86 von 280 nm bis 800 nm angefitteten Simulations-Soll-Messkurve 98. Dieses Mal wurde eine Simplex-Optimierung in dem größeren Intervall 86 von 280 nm bis 800 nm angewandt. Es wurden keine Schichtdickenrelationen berücksichtigt. Die Qualität der Übereinstimmung der beiden Messkurven 92, 98 ist im mittleren Wellenlängenbereich von 480 nm bis 580 nm geringfügig schlechter geworden, jedoch im gesamten Wellenlängenbereich von 280 nm bis 800 nm im Mittel besser.

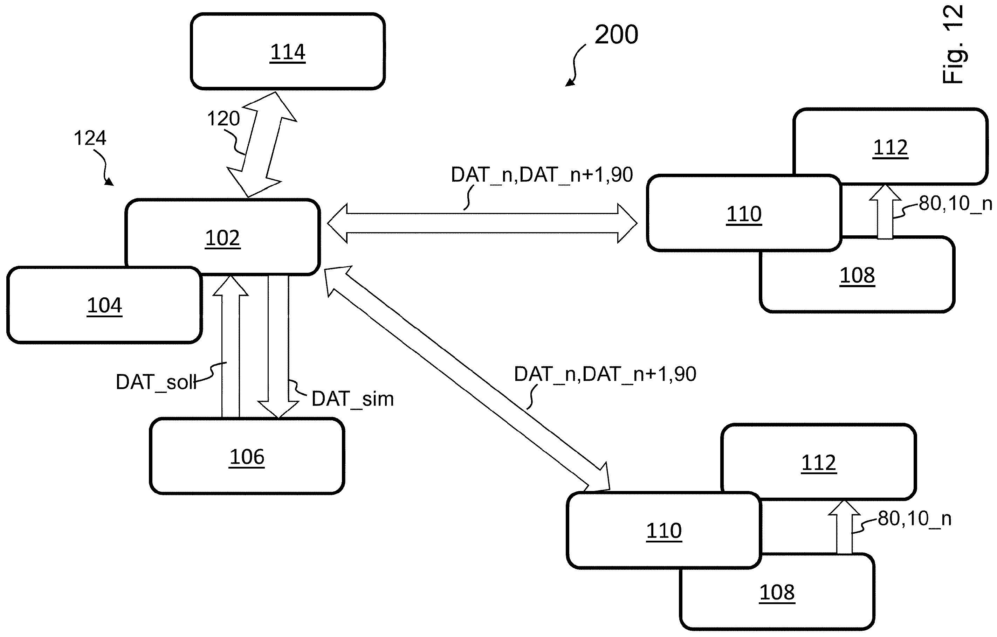

Figur 12 zeigt ein Blockdiagramm eines Systems 200 von Beschichtungsanlagen 108 nach einem weiteren Ausführungsbeispiel der Erfindung. Das System 200 kann auch als eigenständiges System betrachtet werden, das mit einem selbststeuernden und rückgekoppelten Steuerungsprozess nach dem ersten Aspekt der Erfindung betrieben werden kann. Das System 200 von Beschichtungsanlagen 108 zur Herstellung von Schichtsystemen 10 für optische Elemente 80 umfasst dabei zwei Beschichtungsanlagen 108 zum Beschichten eines Substrats 22 mit einem Schichtsystem 10 für ein optisches Element 80, jeweils einen Steuerrechner 110 zum Steuern einer Beschichtungsanlage 108 und zur Kommunikation mit einem Simulationsrechner 102, jeweils ein optisches Messgerät 112 pro Beschichtungsanlage 108 zum Bestimmen einer spektral aufgelösten Ist-Messkurve 90 des Schichtsystems 10, sowie einen Simulationsrechner 102, auf dem eine Simulationssoftware 104 zur optischen Berechnung und Optimierung des Schichtsystems 10 installiert ist, und welcher mit den Steuerungsrechnern 102 der Beschichtungsanlagen 108 kommuniziert. Weiter umfasst das System 200 eine Datenbank 106 zur Speicherung von Anlage-Datensätzen DAT, ein Eingabegerät 114 zur Eingabe und Steuerung des Simulationsrechners 102 und/oder der Beschichtungsanlagen 108. Mit einem solchen System 200 von Beschichtungsanlagen 108 ist es vorteilhaft möglich, mehrere Beschichtungsanlagen 108 über einen Simulationsrechner 102 zu steuern und die Beschichtungsprozesse für die Fertigung von optischen Elementen 80 mit Schichtsystemen 10 einzufahren und/oder zu optimieren.

**Patentansprüche**

1.	System (200) von Beschichtungsanlagen (108) zur Herstellung von Schichtsystemen (10), umfassend wenigstens

	- eine oder mehrere Beschichtungsanlagen (108) zum Beschichten eines Substrats (22) mit einem Schichtsystem (10),
	- einen oder mehrere Steuerrechner (110) zum Steuern wenigstens einer Beschichtungsanlage (108) und zur Kommunikation mit einem Simulationsrechner (102),
	- ein optisches Messgerät (112) zum Bestimmen einer spektral aufgelösten Ist-Messkurve (90) des Schichtsystems (10),

- einen Simulationsrechner (102), auf dem eine Simulationssoftware (104) zur optischen Berechnung und Optimierung des Schichtsystems (10) installiert ist, und welcher mit dem Steuerungsrechner (102) der Beschichtungsanlage (108) kommuniziert,

- eine Datenbank (106) zur Speicherung von Anlage-Datensätzen (DAT),

- ein Eingabegerät (114) zur Eingabe und Steuerung des Simulationsrechners (102) und/oder der einen oder mehreren Beschichtungsanlagen (108),

wobei das System, insbesondere die eine oder mehrere Beschichtungsanlagen (108), ausgebildet ist/-sind, ein Verfahren zum Betreiben wenigstens einer der Beschichtungsanlagen (108) zur Herstellung von Schichtsystemen (10) auszuführen, welches umfasst

(i) Erfassen (S100) wenigstens einer spektralen Messkurve mit Ordinatenwerten und Abszissenwerten als Ist-Messkurve (90) an einem Ist-Schichtensystem (10_n), welches aus einer oder mehreren Einzellagen (11, 12, 13, 14, 15, 16, 17, 18, 19, 20) mit jeweils einer Anlagen-Ist-Schichtdicke (d_ist_11, ..., d_ist_20) der jeweiligen Einzellage (11, 12, 13, 14, 15, 16, 17, 18, 19, 20) besteht, wobei die eine oder mehreren Einzellagen (11, 12, 13, 14, 15, 16, 17, 18, 19, 20) nach einem Anlagen-Datensatz (DAT_n) der wenigstens einen Beschichtungsanlage (108) hergestellt sind, wobei der Anlagen-Datensatz (DAT_n) wenigstens die Anlagen-Ist-Schichtdicke (d_ist_11, ..., d_ist_20) der jeweiligen Einzellage (11, 12, 13, 14, 15, 16, 17, 18, 19, 20) der einen oder mehreren Einzellagen (11, 12, 13, 14, 15, 16, 17, 18, 19, 20) umfasst;

(ii) Zuordnen (S102) der Ist-Messkurve (90) des Ist-Schichtsystems (10_n) nach wenigstens einem Zuordnungskriterium, insbesondere für signifikante spektrale Punkte der Ist-Messkurve (90), zu einer Soll-Messkurve (92) eines Soll-Datensatzes (DAT_soll) mit Ordinatenwerten und Abszissenwerten, dem ein Soll-Datensatz-Schichtsystem (10_soll), gebildet aus einer oder mehreren Einzellagen (11, 12, 13, 14, 15, 16, 17, 18, 19, 20), zugrunde liegt, wobei der Soll-Datensatz (DAT_soll) wenigstens eine bekannte Soll-Schichtdicke (d_soll_11, ..., d_soll_20) der jeweiligen Einzellage (11, 12, 13, 14, 15, 16, 17, 18, 19, 20) der einen oder mehreren Einzellagen (11, 12, 13, 14, 15, 16, 17, 18, 19, 20) umfasst;

(iii) Generieren (S104) einer Simulations-Ist-Messkurve (94) nach einem iterativen Verfahren durch Variieren wenigstens von einer Simulations-Ist-Schichtdicke (g_ist_11, ..., g_ist_20) der jeweiligen Einzellage (11, 12, 13, 14, 15, 16, 17, 18, 19, 20) in zumindest einem spektralen Intervall (82) der Ist-Messkurve (90) und Erhalt eines finalen Simulations-Ist-Datensatzes (DAT_ist_sim) mit wenigstens einer finalen Simulations-Ist-Schichtdicke (g_ist_11, ..., g_ist_20) der jeweiligen Einzellage (11, 12, 13, 14, 15, 16, 17, 18, 19, 20) der einen oder mehreren Einzellagen (11, 12, 13, 14, 15, 16, 17, 18, 19, 20), durch welche die Ist-Messkurve (90) in der Simulations-Ist-Messkurve (94) zumindest angenähert wird, bis ein Abbruchkriterium erreicht ist (S116);

(iv) Generieren (S106) einer Simulations-Soll-Messkurve (98) nach einem iterativen Verfahren durch Variieren wenigstens der Simulations-Soll-Schichtdicke (g_soll_11, ..., g_soll_20) der jeweiligen Einzellage (11, 12, 13, 14, 15, 16, 17, 18, 19, 20) in zumindest einem spektralen Intervall (82) der Soll-Messkurve (92) und Erhalt eines finalen Simulations-Soll-Datensatzes (DAT_soll_sim) mit wenigstens einer finalen Simulations-Soll-Schichtdicke (g_soll_11, ..., g_soll_20) der jeweiligen Einzellage (11, 12, 13, 14, 15, 16, 17, 18, 19, 20) der einen oder mehreren Einzellagen (11, 12, 13, 14, 15, 16, 17, 18, 19, 20), durch welche die Soll-Messkurve (92) in der Simulations-Soll-Messkurve (98) zumindest angenähert wird, bis ein Abbruchkriterium erreicht ist (S116), wobei optische Unterschiede zwischen der Ist-Messkurve (90) und der Simulations-Ist-Messkurve (94) korreliert werden, und der Simulations-Ist-Datensatz (DAT_ist_sim) für eine Rückrechnung der Simulations-Soll-Messkurve (98) zur Soll-Messkurve (92) verwendet wird;

(v) Bereitstellen (S108) des finalen Simulations-Soll-Datensatzes (DAT_soll_sim) für die wenigstens eine Beschichtungsanlage (108) als neuer Anlagen-Datensatz (DAT_n+1) zur Abscheidung eines weiteren Schichtsystems (10_n+1) mit wenigstens einer Korrektur-Ist-Schichtdicke (d_korr_11, ..., d_korr_20) als neue Anlagen-Ist-Schichtdicke (d_ist_11, ..., d_ist_20) der jeweiligen Einzellage (11, 12, 13, 14, 15, 16, 17, 18, 19, 20), welche aus der finalen Simulations-Soll-Schichtdicke (g_soll_11, ..., g_soll_20) der jeweiligen Einzellage (11, 12, 13, 14, 15, 16, 17, 18, 19, 20) der einen oder mehreren Einzellagen (11, 12, 13, 14, 15, 16, 17, 18, 19, 20) mit dem finalen Simulations-Soll-Datensatz (DAT_soll_sim) bestimmt werden.

2. System nach Anspruch 1, wobei das System ausgebildet ist, das Verfahren auszuführen, das weiterhin umfasst, dass das Abbruchkriterium erreicht ist, wenn wenigstens eine der folgenden Bedingungen erfüllt ist:

(i) es wird für das Zuordnungskriterium ein nach einem statistischen Auswahlverfahren stabiles Ergebnis erreicht;
(ii) eine Abweichung zwischen der Ist-Messkurve (90) und der Simulations-Ist-Messkurve (94) liegt innerhalb eines Toleranzbereichs;
(iii) es wurde eine maximale Zahl von Iterationen durchgeführt.

3. System nach Anspruch 1 oder 2,

wobei das System ausgebildet ist, das Verfahren auszuführen, wobei als Startwert der Simulations-Ist-Schichtdicke (g_ist_11, ..., g_ist_20) der jeweiligen Einzellage (11, 12, 13, 14, 15, 16, 17, 18, 19, 20) die Soll-Schichtdicke (d_soll_11, ..., d_soll_20) der jeweiligen Einzellage (11, 12, 13, 14, 15, 16, 17, 18, 19, 20) verwendet wird;
und/oder
wobei das System ausgebildet ist, das Verfahren auszuführen, wobei als Startwert der Simulations-Soll-Schichtdicke (g_soll_11, ..., g_soll_20) der jeweiligen Einzellage (11, 12, 13, 14, 15, 16, 17, 18, 19, 20) die Simulation-Ist-Schichtdicke (g_ist_11, ..., g_ist_20) der jeweiligen Einzellage (11, 12, 13, 14, 15, 16, 17, 18, 19, 20) verwendet wird;
und/oder
wobei das System ausgebildet ist, das Verfahren auszuführen, wobei als Startwert der Simulations-Soll-Schichtdicke (g_soll_11, ..., g_soll_20) der jeweiligen Einzellage (11, 12, 13, 14, 15, 16, 17, 18, 19, 20) eine vorgegebene Schichtdicke der jeweiligen Einzellage (11, 12, 13, 14, 15, 16, 17, 18, 19, 20) verwendet wird.

4. System nach einem der vorhergehenden Ansprüche, wobei das System ausgebildet ist zum Generieren (S104, S106) der Simulations-Ist-Messkurve (94), bzw. Simulations-Soll-Messkurve (98), weiterhin umfassend
Bestimmen (S110) eines Skalierungsfaktors (122) als Mittelwert von Quotienten aus Abszissenwerten der Ist-Messkurve (90), bzw. Simulations-Ist-Messkurve (94) und der Soll-Messkurve (92) für nach dem Zuordnungskriterium bestimmte Abszissenwerte und Skalieren der Soll-Schichtdicke (d_soll_11, ..., d_soll_20); bzw. der Simulations-Ist-Schichtdicke (g_ist_11, ..., g_ist_20) der jeweiligen Einzellage (11, 12, 13, 14, 15, 16, 17, 18, 19, 20) mit dem Skalierungsfaktor (122) als Startwerte der Simulations-Ist-Schichtdicke (g_ist_11, ..., g_ist_20), bzw. der Simulations-Soll-Schichtdicke (g_soll_11, ...,

g_soll_20) der jeweiligen Einzellage (11, 12, 13, 14, 15, 16, 17, 18, 19, 20) der einen oder mehreren Einzellagen (11, 12, 13, 14, 15, 16, 17, 18, 19, 20).

5. System nach einem der vorhergehenden Ansprüche, wobei das System ausgebildet ist zum Generieren (S104, S106) der Simulations-Ist-Messkurve (94), bzw. Simulations-Soll-Messkurve (98), weiterhin umfassend

wenigstens für das erste Intervall (82) für die eine oder jede der mehreren Einzellagen (11, 12, 13, 14, 15, 16, 17, 18, 19, 20) Bilden (S112) eines Quotienten (126) aus der entsprechenden ersten finalen Simulations-Ist-Schichtdicke (g_ist_11, ..., g_ist_20), bzw. der entsprechenden ersten finalen Simulations-Soll-Schichtdicke (g_soll_11, ..., g_soll_20) und der entsprechenden Anlagen-Ist-Schichtdicke (d_ist_11, ..., d_ist_20), wobei eine erste Simulations-Ist-Schichtdicke (g_ist_11, ..., g_ist_20)), bzw. eine Simulations-Soll-Schichtdicke (g_soll_11, ..., g_soll_20) der jeweiligen Einzellage (11, 12, 13, 14, 15, 16, 17, 18, 19, 20) durch Skalieren der Simulations-Ist-Schichtdicke (g_ist_11, ..., g_ist_20), bzw. Simulations-Soll-Schichtdicke (g_soll_11, ..., g_soll_20) der jeweiligen Einzellage (11, 12, 13, 14, 15, 16, 17, 18, 19, 20) der einen oder mehreren Einzellagen (11, 12, 13, 14, 15, 16, 17, 18, 19, 20) mit dem Quotienten (126) generiert werden.

6. System nach Anspruch 5, wobei das System ausgebildet ist zum Generieren (S104, S106) der Simulations-Ist-Messkurve (94), bzw. Simulations-Soll-Messkurve (98), weiterhin umfassend

Überprüfen (S114) der einzelnen ersten Simulations-Ist-Schichtdicke (g_ist_11, ..., g_ist_20), bzw. der einen Simulations-Soll-Schichtdicke (g_soll_11, ..., g_soll_20) der jeweiligen Einzellage (11, 12, 13, 14, 15, 16, 17, 18, 19, 20) auf zumindest ein Kriterium, insbesondere eine Plausibilität und/oder eine vorgegebene Abweichung von der jeweiligen Soll-Schichtdicke (g_soll_11, ..., g_soll_20) der Soll-Messkurve (94),
und, sofern das wenigstens eine Kriterium verfehlt wird,
Wiederholen des Variierens (S104, S106) der Simulations-Ist-Schichtdicke (g_ist_11, ..., g_ist_20), bzw. der Simulations-Soll-Schichtdicke (g_soll_11, ..., g_soll_20) der jeweiligen Einzellage (11, 12, 13, 14, 15, 16, 17, 18, 19, 20) und des Bereitstellens (S108) von einer ersten finalen Simulations-Ist-Schichtdicke (g_ist_11, ..., g_ist_20) bzw. Simulations-Soll-Schichtdicke (g_soll_11, ..., g_soll_20) der jeweiligen Einzellage (11, 12, 13, 14, 15, 16, 17, 18, 19, 20) sowie des Generierens der ersten Simulations-Ist-Schichtdicke (g_ist_11, ..., g_ist_20), bzw. Simulations-Soll-Schichtdicke (g_soll_11, ..., g_soll_20), wobei für die jeweilige Einzellage (11, 12, 13, 14, 15, 16, 17, 18, 19, 20) der einen oder mehreren Einzellagen (11, 12, 13, 14, 15, 16, 17, 18, 19, 20), welche das Kriterium verfehlt hat, eine Beschränkung beim Variieren (S104, S106) vorgegeben wird, und Bereitstellen von einer zweiten Simulations-Ist-Schichtdicke (g_ist_11, ..., g_ist_20), bzw. Simulations-Soll-Schichtdicke (g_soll_11, ..., g_soll_20) der jeweiligen Einzellage (11, 12, 13, 14, 15, 16, 17, 18, 19, 20) der einen oder mehreren Einzellagen (11, 12, 13, 14, 15, 16, 17, 18, 19, 20).

7. System nach einem der Ansprüche 5 bis 6, wobei das System ausgebildet ist zum

Wiederholen der Schritte (S104, S106, S112, S113, S114, S115) in einem oder mehreren weiteren spektralen Intervallen (84, 86), wobei jedes folgende Intervall (84, 86) das vorausgegangene Intervall (82, 84) einschließt, wobei die zweite Simulations-Ist-Schichtdicke (g_ist_11, ..., g_ist_20), bzw. Simulations-Soll-Schichtdicke (g_soll_11, ..., g_soll_20) der jeweiligen Einzellage (11, 12, 13, 14, 15, 16, 17, 18, 19, 20) des vorausgegangenen Intervalls (82, 84) im folgenden Intervall (84, 86) als Startwerte eingesetzt werden und Bereitstellen von einer finalen Simulations-Ist-Schichtdicke (g_ist_11, ..., g_ist_20), bzw. Simulations-Soll-Schichtdicke (g_soll_11, ..., g_soll_20) der jeweiligen Einzellage (11, 12, 13, 14, 15, 16, 17, 18, 19, 20) der einen oder mehreren Einzellagen (11, 12, 13, 14, 15, 16, 17, 18, 19, 20).

8. System nach einem der Ansprüche 1 bis 7, wobei das System ausgebildet ist, dass ein interferometrisch reflexminderndes Schichtsystem (10) auf wenigstens einer Oberfläche (24) eines Substrats (22) abgeschieden wird,

wobei das Schichtsystem (10) einen Stapel (40) von mindestens vier aufeinander folgenden Schichtpaketen (42, 44, 46, 48, 50) umfasst, wobei jedes Schichtpaket (42, 44, 46, 48, 50) ein Paar von ersten und zweiten Einzellagen (11, 12, 13, 14, 15, 16, 17, 18, 19, 20) umfasst, wobei die ersten Einzellagen (11, 13, 15, 17, 19) eine erste optische Dicke (t1) und die zweiten Einzellagen (12, 14, 16, 18, 20) eine zweite, von der ersten optischen Dicke (t1) verschiedene optische Dicke (t2) aufweisen, wobei ein Brechungsindex (n1) der jeweils substratnäheren ersten Einzellagen (11, 13, 15, 17, 19) größer ist als ein Brechungsindex (n2) der jeweils substratferneren zweiten Einzellagen (12, 14, 16, 18, 20) des Stapels (40), wobei das Schichtsystem (10) eine Helligkeit (L*), eine Buntheit (C*) und einen Bunttonwinkel (h) einer Restreflexfarbe aufweist, wobei der Betrag einer Änderung (Δh) des Bunttonwinkels (h) der Restreflexfarbe in einem Intervall eines Betrachtungswinkels (AOI) mit den Grenzwerten 0° und 30° bezogen auf eine Oberflächennormale (70) auf das Schichtsystem (10) kleiner als der Betrag einer Änderung (ΔC*) der Buntheit (C*) im Intervall des Betrachtungswinkels (AOI) ist, wobei folgende Schritte ausgeführt werden:

- Definieren eines Schichtdesigns, umfassend zumindest ein erstes Material für hochbrechende erste Einzellagen (11, 13, 15, 17, 19) und ein zweites Material für niedrigbrechende zweite Einzellagen (12, 14, 16, 18, 20), Anzahl gewünschter Schichtpakete (42, 44, 46, 48, 50) mit den Einzellagen (11, 12, 13, 14, 15, 16, 17, 18, 19, 20), Startwerte der Dicke der Einzellagen (11, 12, 13, 14, 15, 16, 17, 18, 19, 20);
- Definieren von Ziel-Farbwerten, umfassend Helligkeit (L*), Buntheit (C*) und Bunttonwinkel (h) zumindest an Grenzwerten für ein Intervall eines Betrachtungswinkels (AOI) mit Grenzwerten von 0° und 30°;
- Durchführen eines Optimierungsverfahrens zur Variation der Einzelschichtdicken (d_ist_11, ..., d_ist_20), bis ein Optimierungsziel erreicht ist.

9. System nach Anspruch 8,

wobei das System ausgebildet ist, dass der Bunttonwinkel (h) im Intervall des Betrachtungswinkels (AOI) mit den Grenzwerten 0° und 30° sich um höchstens 15° ändert, bevorzugt um höchstens 10° ändert; und/oder wobei das System ausgebildet ist, dass der Betrag der Änderung (Δh) des Bunttonwinkels (h) in einem zweiten Intervall eines Betrachtungswinkels (AOI) von 0° bis zu einem Grenzbetrachtungswinkel (Θ) mit einem oberen Grenzwert zwischen 30° und 45° bezogen auf die Oberflächennormale (70) auf das Schichtsystem (10) kleiner als der Betrag einer Änderung (ΔC*) der Buntheit (C*) im zweiten Intervall des Betrachtungswinkels (AOI) ist und der Betrag der Buntheit (C*) beim Grenzbetrachtungswinkel (Θ) mindestens 2 ist, insbesondere wobei der Bunttonwinkel (h) im zweiten Intervall sich höchstens um 20° ändert, bevorzugt höchstens um 15° ändert;

und/oder

wobei das System ausgebildet ist, dass der photopische Reflexionsgrad (Rv) im Intervall des Betrachtungswinkels (AOI) mit den Grenzwerten 0° und 30° höchstens 1,5%, bevorzugt höchstens 1,2% ist;

und/oder

wobei das System ausgebildet ist, dass der skotopische Reflexionsgrad (Rv') im Intervall des Betrachtungswinkels (AOI) mit den Grenzwerten 0° und 30° höchstens 1,5%, bevorzugt höchstens 1,2% ist.

10. Verfahren zur Herstellung eines Schichtsystems (10) in wenigstens einer Beschichtungsanlage (108) mit einem Verfahren in einem System (200) nach einem der vorhergehenden Ansprüche, wobei das Schichtsystem (10) basierend auf einem finalen Simulations-Soll-Datensatz (DAT_soll_sim) für die Beschichtungsanlage (108) hergestellt wird.

11. Beschichtungsanlage (108) zur Herstellung eines Schichtsystems (10), mit einem Verfahren in einem System (200) nach wenigstens Anspruch 1, umfassend wenigstens eines der folgenden

(i) eine Komponente (116) zur Anwendung eines künstlichen Alterungsprozesses auf das Schichtsystem (10),

(ii) ein optisches Messgerät (118) zum Bestimmen einer spektral aufgelösten Ist-Messkurve (90) des Schichtsystems (10).

12. Computer-Programm-Produkt für ein Verfahren zum Betreiben wenigstens einer Beschichtungsanlage (108) zur Herstellung von Schichtsystemen (10), wobei das Computer-Programm-Produkt wenigstens ein computerlesbares Speichermedium umfasst, welches Programmbefehle umfasst, die auf einem Computersystem (102) ausführbar sind und das Computersystem (102) dazu veranlassen, ein Verfahren auszuführen in einem System (100) nach wenigstens Anspruch 1.

**Claims**

1. System (200) of coating apparatuses (108) for producing coating systems (10), comprising at least

- one or more coating installations (108) for coating a substrate (22) with a coating apparatus (10),
- one or more control computers (110) for controlling at least one coating apparatus (108) and for communicating with a simulation computer (102),
- an optical measuring device (112) for determining a spectrally resolved actual measurement curve (90) of the coating system (10),

- a simulation computer (102) on which simulation software (104) for the optical calculation and optimization of the coating system (10) is installed and which communicates with the control computer (102) of the coating apparatus (108),

- a database (106) for storing apparatus data records (DAT),

- an input device (114) for inputting and controlling the simulation computer (102) and/or the one or more coating apparatuses (108),

wherein the system, in particular the one or more coating apparatuses (108), is/are designed to execute a method for operating at least one of the coating apparatuses (108) for producing coating systems (10), which comprises

(i) Recording (S100) at least one spectral measurement curve with ordinate values and abscissa values as an actual measurement curve (90) on an actual layer system (10_n), which consists of one or more individual layers (11, 12, 13, 14, 15, 16, 17, 18, 19, 20), each with an actual layer thickness (d_ist_11, ..., d_ist_20) of the respective individual layer (11, 12, 13, 14, 15, 16, 17, 18, 19, 20), wherein the one or more individual layers (11, 12, 13, 14, 15, 16, 17, 18, 19, 20) are produced according to an apparatus data set (DAT_n) of the at least one coating apparatus (108), wherein the apparatus data set (DAT_n) contains at least the apparatus actual layer thickness (d_ist_11, ..., d_ist_20) of the respective individual layer (11, 12, 13, 14, 15, 16, 17, 18, 19, 20) of the one or more individual layers (11, 12, 13, 14, 15, 16, 17, 18, 19, 20);

(ii) Assigning (S102) the actual measurement curve (90) of the actual layer system (10_n) according to at least one assignment criterion, in particular for significant spectral points of the actual measurement curve (90), to a target measurement curve (92) of a target data set (DAT_soll) with ordinate values and abscissa values, which is based on a target data set layer system (10_soll) formed from one or more individual layers (11, 12, 13, 14, 15, 16, 17, 18, 19, 20), wherein the target data set (DAT_soll) has at least one known target layer thickness (d_soll_11, ..., d_soll_20) of the respective individual layer (11, 12, 13, 14, 15, 16, 17, 18, 19, 20) of the one or more individual layers (11, 12, 13, 14, 15, 16, 17, 18, 19, 20);

(iii) generating (S104) a simulation actual measurement curve (94) according to an iterative method by varying at least one simulation actual layer thickness (g_ist_11, ..., g_ist_20) of the respective individual layer (11, 12, 13, 14, 15, 16, 17, 18, 19, 20) in at least one spectral interval (82) of the actual measurement curve (90) and obtaining a final simulation actual data set (DAT_ist_sim) with at least one final simulation actual layer thickness (g_ist_11, ..., g_ist_20) of the respective individual layer (11, 12, 13, 14, 15, 16, 17, 18, 19, 20) of the one or more individual layers (11, 12, 13, 14, 15, 16, 17, 18, 19, 20), by which the actual measurement curve (90) is at least approximated in the simulation actual measurement curve (94), until a termination criterion is reached (S116);

(iv) Generating (S106) a simulation target measurement curve (98) according to an iterative method by varying at least the simulation target layer thickness (g_soll_11, ..., g_soll_20) of the respective individual layer (11, 12, 13, 14, 15, 16, 17, 18, 19, 20) in at least one spectral interval (82) of the target measurement curve (92) and obtaining a final simulation target data set (DAT_soll_sim) with at least one final simulation target layer thickness (g_soll_11, ..., g_soll_20) of the respective individual layer (11, 12, 13, 14, 15, 16, 17, 18, 19, 20) of the one or more individual layers (11, 12, 13, 14, 15, 16, 17, 18, 19, 20), by which the target measurement curve (92) is at least approximated in the simulation target measurement curve (98), until a termination criterion is reached (S116), whereby optical differences between the actual measurement curve (90) and the simulation actual measurement curve (94) are correlated, and the simulation actual data set (DAT_ist_sim) is used for a recalculation of the simulation target measurement curve (98) to the target measurement curve (92) ;

(v) Providing (S108) the final simulation target data set (DAT_soll_sim) for the at least one coating apparatus (108) as a new apparatus data set (DAT_n+1)for depositing a further layer system (10_n+1) with at least one corrected actual layer thickness (d_korr_11, ..., d_korr_20) as the new apparatus actual layer thickness (d_ist_11, ..., d_ist_20) of the respective individual layer (11, 12, 13, 14, 15, 16, 17, 18, 19, 20), which is calculated from the final simulation target layer thickness (g_soll_11, ..., g_soll_20) of the respective individual layer (11, 12, 13, 14, 15, 16, 17, 18, 19, 20) of one or more individual layers (11, 12, 13, 14, 15, 16, 17, 18, 19, 20) with the final simulation target data set (DAT_soll_sim).

2. System according to claim 1, wherein the system is configured to perform the method, which further comprises determining that the termination criterion is met when at least one of the following conditions is satisfied:

(i) a stable result is achieved for the assignment criterion according to a statistical selection procedure;

(ii) a deviation between the actual measurement curve (90) and the simulation actual measurement curve (94) is within a tolerance range;

(iii) a maximum number of iterations has been performed.

3. System according to claim 1 or 2,

wherein the system is configured to perform the method, wherein the start value of the simulated actual layer thickness (g_ist_11, ..., g_ist_20) of the respective individual layer (11, 12, 13, 14, 15, 16, 17, 18, 19, 20) is used as the start value of the simulation actual layer thickness (g_ist_11, ..., g_ist_20) of the respective individual layer (11, 12, 13, 14, 15, 16, 17, 18, 19, 20);
and/or
wherein the system is designed to execute the method, wherein the start value of the simulation target layer thickness (g_ist_11, ..., g_ist_20) of the respective individual layer (11, 12, 13, 14, 15, 16, 17, 18, 19, 20) is used as the start value of the simulation target layer thickness (g_ist_11, ..., g_ist_20) of the respective individual layer (11, 12, 13, 14, 15, 16, 17, 18, 19, 20);
and/or
wherein the system is designed to execute the method, wherein a predetermined layer thickness of the respective individual layer (11, 12, 13, 14, 15, 16, 17, 18, 19, 20) is used as the start value of the simulation target layer thickness (g_soll_11, ..., g_soll_20) of the respective individual layer (11, 12, 13, 14, 15, 16, 17, 18, 19, 20).

4. System according to one of the preceding claims, wherein the system is designed to generate (S104, S106) the simulation actual measurement curve (94) and simulation target measurement curve (98), further comprising
determining (S110) a scaling factor (122) as the mean value of quotients from abscissa values of the actual measurement curve (90) or simulation actual measurement curve (94) and the target measurement curve (92) for abscissa values determined according to the assignment criterion, and scaling the target layer thickness (d_soll_11, ..., d_soll_20); or the simulated actual layer thickness (g_ist_11, ..., g_ist_20) of the respective individual layer (11, 12, 13, 14, 15, 16, 17, 18, 19, 20) with the scaling factor (122) as start values for the simulated actual layer thickness (g_ist_11, ..., g_ist_20) or the simulated target layer thickness (g_soll_11, ..., g_soll_20) of the respective individual layer (11, 12, 13, 14, 15, 16, 17, 18, 19, 20) of one or more individual layers (11, 12, 13, 14, 15, 16, 17, 18, 19, 20).

5. System according to one of the preceding claims, wherein the system is designed to generate (S104, S106) the simulation actual measurement curve (94) and simulation target measurement curve (98), respectively, further comprising
at least for the first interval (82) for one or each of the multiple individual layers (11, 12, 13, 14, 15, 16, 17, 18, 19, 20), forming (S112) a quotient (126) from the corresponding first final simulation actual layer thickness (g_ist_11, ..., g_ist_20) or the corresponding first final simulation target layer thickness (g_soll_11, ..., g_soll_20) and the corresponding actual layer thickness of the apparatus (d_ist_11, ..., d_ist_20), wherein a first actual simulation layer thickness (g_ist_11, ..., g_ist_20) or a target simulation layer thickness (g_soll_11, ..., g_soll_20) of the respective individual layer (11, 12, 13, 14, 15, 16, 17, 18, 19, 20) by scaling the simulation actual layer thickness (g_ist_11, ..., g_ist_20), or simulation target layer thickness (g_soll_11, ..., g_soll_20) of the respective individual layer (11, 12, 13, 14, 15, 16, 17, 18, 19, 20) of one or more individual layers (11, 12, 13, 14, 15, 16, 17, 18, 19, 20) with the quotient (126).

6. System according to claim 5, wherein the system is designed to generate (S104, S106) the simulation actual measurement curve (94) and simulation target measurement curve (98), further comprising

checking (S114) the individual first simulation actual layer thicknesses (g_ist_11, ..., g_ist_20) or the one simulation target layer thickness (g_soll_11, ..., g_soll_20) of the respective individual layer (11, 12, 13, 14, 15, 16, 17, 18, 19, 20) against at least one criterion, in particular plausibility and/or a specified deviation from the respective target layer thickness (g_soll_11, ..., g_soll_20) of the target measurement curve (94),
and, if the at least one criterion is not met,
Repeat varying (S104, S106) the simulated actual layer thickness (g_ist_11, ..., g_ist_20) or the simulated target layer thickness (g_soll_11, ..., g_soll_20) of the respective individual layer (11, 12, 13, 14, 15, 16, 17, 18, 19, 20) and providing (S108) a first final simulation actual layer thickness (g_ist_11, ..., g_ist_20) or simulation target layer thickness (g_soll_11, ..., g_soll_20) of the respective individual layer (11, 12, 13, 14, 15, 16, 17, 18, 19, 20) and generating the first simulated actual layer thickness (g_ist_11, ..., g_ist_20) or simulated target layer thickness (g_soll_11, ..., g_soll_20), whereby for the respective individual layer (11, 12, 13, 14, 15, 16, 17, 18, 19, 20) of the one or more individual layers (11, 12, 13, 14, 15, 16, 17, 18, 19, 20) that has failed to meet the criterion, a restriction is specified for variation (S104, S106), and
providing a second simulation actual layer thickness (g_ist_11, ..., g_ist_20) or simulation target layer thickness (g_soll_11, ..., g_soll_20) of the respective individual layer (11, 12, 13, 14, 15, 16, 17, 18, 19, 20) of one or more individual layers (11, 12, 13, 14, 15, 16, 17, 18, 19, 20).

7. System according to one of claims 5 to 6, wherein the system is designed to

repeating the steps (S104, S106, S112, S113, S114, S115) in one or more further spectral intervals (84, 86), each subsequent interval (84, 86) including the preceding interval (82, 84), wherein the second simulation actual layer thickness (g_ist_11, ..., g_ist_20) or simulation target layer thickness (g_soll_11, ..., g_soll_20) of the respective individual layer (11, 12, 13, 14, 15, 16, 17, 18, 19, 20) of the preceding interval (82, 84) are used as start values in the following interval (84, 86) and
provision of a final simulation actual layer thickness (g_ist_11, ..., g_ist_20) or simulation target layer thickness (g_soll_11, ..., g_soll_20) of the respective individual layer (11, 12, 13, 14, 15, 16, 17, 18, 19, 20) of one or more individual layers (11, 12, 13, 14, 15, 16, 17, 18, 19, 20).

8. System according to any one of claims 1 to 7, wherein the system is designed such that an interferometrically reflective layer system (10) is deposited on at least one surface (24) of a substrate (22),

wherein the layer system (10) comprises a stack (40) of at least four consecutive layer packages (42, 44, 46, 48, 50), each layer package (42, 44, 46, 48, 50) comprising a pair of first and second individual layers (11, 12, 13, 14, 15, 16, 17, 18, 19, 20), wherein the first individual layers (11, 13, 15, 17, 19) have a first optical thickness (t1) and the second individual layers (12, 14, 16, 18, 20) have a second optical thickness (t2) that differs from the first optical thickness (t1),
wherein a refractive index (n1) of the respective first individual layers (11, 13, 15, 17, 19) closer to the substrate is greater than a refractive index (n2) of the respective second individual layers (12, 14, 16, 18, 20) of the stack (40) farther from the substrate,
wherein the layer system (10) has a brightness (L*), a chroma (C*) and a hue angle (h) of a residual reflection color,
wherein the amount of change (Δh) in the hue angle (h) of the residual reflection color in an interval of a viewing angle (AOI) with the limits 0° and 30° relative to a surface normal (70) to the layer system (10) is smaller than the amount of change (ΔC*) in the chroma (C*) in the viewing angle interval (AOI), wherein the following steps are performed:

> - Defining a layer design comprising at least a first material for high-refractive first individual layers (11, 13, 15, 17, 19) and a second material for low-refractive second individual layers (12, 14, 16, 18, 20), number of desired layer packages (42, 44, 46, 48, 50) with the individual layers (11, 12, 13, 14, 15, 16, 17, 18, 19, 20), starting values for the thickness of the individual layers (11, 12, 13, 14, 15, 16, 17, 18, 19, 20);
> - Defining target color values, comprising brightness (L*), chroma (C*) and hue angle (h) at least at limit values for an angle of view (AOI) interval with limit values of 0° and 30°;
> - Performing an optimization process to vary the individual layer thicknesses (d_ist_11, ..., d_ist_20) until an optimization target is achieved.

9. System according to claim 8,

> wherein the system is designed such that the hue angle (h) in the viewing angle interval (AOI) with limit values of 0° and 30° changes by a maximum of 15°, preferably by a maximum of 10°;
> and/or
> wherein the system is designed such that the amount of change (Δh) in the hue angle (h) in a second viewing angle (AOI) interval from 0° to a limit viewing angle (Θ) with an upper limit value between 30° and 45° relative to the surface normal (70) on the layer system (10) is smaller than the amount of a change (ΔC*) in the colorfulness (C*) in the second interval of the viewing angle (AOI) and the amount of chromaticity (C*) at the limit viewing angle (Θ) is at least 2, in particular wherein the hue angle (h) in the second interval changes by at most 20°, preferably by at most 15°;
> and/or
> wherein the system is designed such that the photopic reflectance (Rv) in the viewing angle (AOI) interval with the limit values 0° and 30° is at most 1.5%, preferably at most 1.2%;
> and/or
> wherein the system is designed such that the scotopic reflectance (Rv') in the viewing angle (AOI) interval with the limits 0° and 30° is at most 1.5%, preferably at most 1.2%.

10. Method for producing a coating system (10) in at least one coating apparatus (108) using a method in a system (200) according to one of the preceding claims, wherein the coating system (10) is produced based on a final simulation target data set (DAT_soll_sim) for the coating apparatus (108).

11. Coating apparatus (108) for producing a coating system (10), with a method in a system (200) according to at least claim 1, comprising at least one of the following

> (i) a component (116) for applying an artificial aging process to the coating system (10),
> (ii) an optical measuring device (118) for determining a spectrally resolved actual measurement curve (90) of the coating system (10).

12. Computer program product for a method for operating at least one coating apparatus (108) for producing coating systems (10), wherein the computer program product comprises at least one computer-readable storage medium comprising program instructions executable on a computer system (102) and causing the computer system (102) to perform a method in a system (100) according to at least claim 1.

**Revendications**

1. Système (200) d'installations de revêtement (108) pour la fabrication de systèmes de couches (10), comprenant au moins

> - une ou plusieurs installations de revêtement (108) pour revêtir un substrat (22) avec un système de couches (10),
> - un ou plusieurs ordinateurs de commande (110) pour commander au moins une installation de revêtement (108) et pour communiquer avec un ordinateur de simulation (102),
> - un appareil de mesure optique (112) pour déterminer une courbe de mesure réelle (90), résolue spectralement, du système de couches (10),
> - un ordinateur de simulation (102), sur lequel est installé un logiciel de simulation (104) pour le calcul optique et l'optimisation du système de couches (10), et qui communique avec l'ordinateur de commande (102) de l'installation de revêtement (108),
> - une base de données (106) pour le stockage des enregistrements de données de l'installation (DAT),
> - un dispositif d'entrée (114) pour l'entrée et la commande de l'ordinateur de simulation (102) et/ou de l'une ou de plusieurs installations de revêtement (108),

le système, en particulier l'une ou plusieurs installations de revêtement (108), étant conçu pour exécuter un procédé d'exploitation d'au moins l'une des installations de revêtement (108) pour la fabrication de systèmes de couches (10), qui comprend

(i) saisie (S100) d'au moins une courbe de mesure spectrale avec des valeurs d'ordonnées et des valeurs d'abscisses comme courbe de mesure réelle (90) sur un système de couches réelles (10_n) qui est constitué d'une ou de plusieurs couches individuelles (11, 12, 13, 14, 15, 16, 17, 18, 19, 20) avec respectivement une épaisseur de couche réelle d'installation (d_ist_11, ...d_ist_20) de la couche individuelle respective (11, 12, 13, 14, 15, 16, 17, 18, 19, 20), une ou plusieurs couches individuelles (11, 12, 13, 14, 15, 16, 17, 18, 19, 20) étant fabriquées selon un jeu de données d'installation (DAT_n) de la au moins une installation de revêtement (108), le jeu de données d'installation (DAT_n) contenant au moins l'épaisseur de couche réelle d'installation (d_ist_11, ...d_ist_20) de la couche individuelle respective (11, 12, 13, 14, 15, 16, 17, 18, 19, 20) d'une ou de plusieurs couches individuelles (11, 12, 13, 14, 15, 16, 17, 18, 19, 20) ;

(ii) l'affectation (S102) de la courbe de mesure réelle (90) du système de couches réel (10_n) selon au moins un critère d'affectation, en particulier pour des points spectraux significatifs de la courbe de mesure réelle (90), à une courbe de mesure de consigne (92) d'un ensemble de données de consigne (DAT_soll) avec des valeurs d'ordonnées et des valeurs d'abscisses, à la base duquel se trouve un système de couches de jeu de données de consigne (10_soll), formé d'une ou de plusieurs couches individuelles (11, 12, 13, 14, 15, 16, 17, 18, 19, 20), le jeu de données de consigne (DAT_soll) présentant au moins une épaisseur de couche de consigne connue (d_soll_11, ..., d_soll_20) de la couche individuelle respective (11, 12, 13, 14, 15, 16, 17, 18, 19, 20) d'une ou de plusieurs couches individuelles (11, 12, 13, 14, 15, 16, 17, 18, 19, 20) ;

(iii) générer (S104) une courbe de mesure réelle de simulation (94) selon un procédé itératif en faisant varier au moins une épaisseur de couche réelle de simulation (g_ist_11, ...g_ist_20) de la couche individuelle respective (11, 12, 13, 14, 15, 16, 17, 18, 19, 20) dans au moins un intervalle spectral (82) de la courbe de mesure réelle (90) et obtention d'un jeu de données réel de simulation final (DAT_ist_sim) avec au moins une épaisseur de couche réelle de simulation finale (g_ist_11, ..., g_ist_20) de la couche individuelle respective (11, 12, 13, 14, 15, 16, 17, 18, 19, 20) d'une ou de plusieurs couches individuelles (11, 12, 13, 14, 15, 16, 17, 18, 19, 20), par laquelle la courbe de mesure réelle (90) est au moins approchée dans la courbe de mesure réelle de simulation (94), jusqu'à ce qu'un critère d'interruption soit atteint (S116) ;

(iv) Générer (S106) une courbe de mesure de consigne de simulation (98) selon un procédé itératif en faisant varier au moins l'épaisseur de couche de consigne de simulation (g_soll_11, ...g_soll_20) de la couche individuelle respective (11, 12, 13, 14, 15, 16, 17, 18, 19, 20) dans au moins un intervalle spectral (82) de la courbe de mesure théorique (92) et obtention d'un jeu de données théorique de simulation final (DAT_soll_sim) avec au moins une épaisseur de couche théorique de simulation finale (g_soll_11, ..., g_soll_20) de la couche individuelle respective (11, 12, 13, 14, 15, 16, 17, 18, 19, 20) d'une ou de plusieurs couches individuelles (11, 12, 13, 14, 15, 16, 17, 18, 19, 20), par laquelle la courbe de mesure théorique (92) est au moins approchée dans la courbe de mesure théorique de simulation (98) jusqu'à ce qu'un critère d'interruption soit atteint (S116), des différences optiques entre la courbe de mesure réelle (90) et la courbe de mesure réelle de simulation (94) étant corrélées, et l'ensemble de données réelles de simulation (DAT_ist_sim) étant utilisé pour un calcul rétroactif de la courbe de mesure théorique de simulation (98) par rapport à la courbe de mesure théorique (92) ;

(v) mise à disposition (S108) de l'ensemble de données de consigne de simulation final (DAT_soll_sim) pour l'au moins une installation de revêtement (108) comme nouvel ensemble de données d'installation (DAT_n+1) pour le dépôt d'un autre système de couches (10_n+1) avec au moins une épaisseur de couche réelle de correction (d_korr_11, ..., d_korr_20) comme nouvelle épaisseur de couche réelle d'installation (d_ist_11, ..., d_korr_20).d_ist_20) de la couche individuelle respective (11, 12, 13, 14, 15, 16, 17, 18, 19, 20), qui est calculée à partir de l'épaisseur de couche théorique finale de simulation (g_soll_11, ..., g_soll_20) de la couche individuelle respective (11, 12, 13, 14, 15, 16, 17, 18, 19, 20) d'une ou de plusieurs couches individuelles (11, 12, 13, 14, 15, 16, 17, 18, 19, 20) sont déterminées avec le jeu de données de consigne de simulation final (DAT_soll_sim).

2.  Système selon la revendication 1, dans lequel le système est adapté pour exécuter le procédé, qui comprend en outre que le critère d'abandon est atteint lorsqu'au moins l'une des conditions suivantes est remplie :

(i) un résultat stable selon un procédé de sélection statistique est obtenu pour le critère d'attribution ;

(ii) un écart entre la courbe de mesure réelle (90) et la courbe de mesure réelle de simulation (94) se situe dans une plage de tolérance ;

(iii) un nombre maximal d'itérations a été effectué.

3. Système selon la revendication 1 ou 2,

le système étant conçu pour exécuter le procédé, l'épaisseur de couche théorique (d_soll_11, ..., d_soll_20) de la couche individuelle respective (11, 12, 13, 14, 15, 16, 17, 18, 19, 20) étant utilisée comme valeur initiale de l'épaisseur de couche réelle de simulation (g_ist_11, ..., g_ist_20) ;
et/ou
le système étant conçu pour exécuter le procédé, en utilisant comme valeur de départ de l'épaisseur de couche de consigne de simulation (g_soll_11, ..., g_soll_20) de la couche individuelle respective (11, 12, 13, 14, 15, 16, 17, 18, 19, 20) l'épaisseur de couche réelle de simulation (g_ist_11, ..., g_ist_20) de la couche individuelle respective (11, 12, 13, 14, 15, 16, 17, 18, 19, 20) ;
et/ou
le système étant conçu pour exécuter le procédé, une épaisseur de couche prédéfinie de la couche individuelle respective (11, 12, 13, 14, 15, 16, 17, 18, 19, 20) étant utilisée comme valeur de départ de l'épaisseur de couche de consigne de simulation (g_soll_11, ..., g_soll_20) de la couche individuelle respective (11, 12, 13, 14, 15, 16, 17, 18, 19, 20).

4. Système selon l'une des revendications précédentes, le système étant conçu pour générer (S104, S106) la courbe de mesure réelle de simulation (94), respectivement la courbe de mesure théorique de simulation (98), comprenant en outre
détermination (S110) d'un facteur d'échelle (122) en tant que valeur moyenne de quotients de valeurs d'abscisses de la courbe de mesure réelle (90), respectivement de la courbe de mesure réelle de simulation (94) et de la courbe de mesure de consigne (92) pour des valeurs d'abscisses déterminées selon le critère d'attribution et mise à l'échelle de l'épaisseur de couche de consigne (d_soll_11, ..., d_soll_20) ; respectivement de l'épaisseur de couche réelle de simulation (g_ist_11, ..., g_ist_20) de la couche individuelle respective (11, 12, 13, 14, 15, 16, 17, 18, 19, 20) avec le facteur de mise à l'échelle (122) comme valeurs de départ de l'épaisseur de couche réelle de simulation (g_ist_11, ..., g_ist_20), resp. de l'épaisseur de couche de consigne de simulation (g_soll_11, ..., g_soll_20) de la couche individuelle respective (11, 12, 13, 14, 15, 16, 17, 18, 19, 20) d'une ou de plusieurs couches individuelles (11, 12, 13, 14, 15, 16, 17, 18, 19, 20).

5. Système selon l'une quelconque des revendications précédentes, le système étant adapté pour générer (S104, S106) la courbe de mesure réelle de simulation (94), respectivement la courbe de mesure théorique de simulation (98), comprenant en outre former (S112), au moins pour le premier intervalle (82), pour l'une ou chacune de la pluralité de couches individuelles (11, 12, 13, 14, 15, 16, 17, 18, 19, 20), un quotient (126) de la première épaisseur de couche réelle de simulation finale correspondante (g_ist_11, ..., g_ist_20), resp. de la première épaisseur de couche de consigne de simulation finale correspondante (g_soll_11, ..., g_soll_20) et de l'épaisseur de couche réelle d'installation correspondante (d_ist_11, ..., d_ist_20), une première épaisseur de couche réelle de simulation (g_ist_11, ..., g_ist_20), resp. une épaisseur de couche de consigne de simulation (g_soll_11, ..., g_soll_20) de la couche individuelle respective (11, 12, 13, 14, 15, 16, 17, 18, 19, 20) par mise à l'échelle de l'épaisseur de couche réelle de simulation (g_ist_11, ..., g_ist_20), resp. épaisseur de couche de consigne de simulation (g_soll_11, ..., g_soll_20) de la couche individuelle respective (11, 12, 13, 14, 15, 16, 17, 18, 19, 20) d'une ou de plusieurs couches individuelles (11, 12, 13, 14, 15, 16, 17, 18, 19, 20) sont générées avec le quotient (126).

6. Système selon la revendication 5, le système étant conçu pour générer (S104, S106) la courbe de mesure réelle de simulation (94), respectivement la courbe de mesure théorique de simulation (98), comprenant en outre

vérifier (S114) l'unique première épaisseur de couche réelle de simulation (g_ist_11, ..., g_ist_20), resp. de la seule épaisseur de couche de consigne de simulation (g_soll_11, ..., g_soll_20) de la couche individuelle respective (11, 12, 13, 14, 15, 16, 17, 18, 19, 20) sur au moins un critère, en particulier une plausibilité et/ou un écart prédéterminé par rapport à l'épaisseur de couche de consigne respective (g_soll_11, ..., g_soll_20) de la courbe de mesure de consigne (94),
et, dans la mesure où l'au moins un critère n'est pas atteint,
Répéter la variation (S104, S106) de l'épaisseur de couche réelle de simulation (g_ist_11, ..., g_ist_20), resp. l'épaisseur de couche de consigne de simulation (g_soll_11, ..., g_soll_20) de la couche individuelle respective (11, 12, 13, 14, 15, 16, 17, 18, 19, 20) et la mise à disposition (S108) d'une première épaisseur de couche réelle de simulation finale (g_ist_11, ..., g_ist_20) ou d'une seconde épaisseur de couche réelle de simulation finale (g_ist_20). épaisseur de couche de consigne de simulation (g_soll_11, ..., g_soll_20) de la couche individuelle respective (11, 12, 13, 14, 15, 16, 17, 18, 19, 20) ainsi que la génération de la première épaisseur de couche réelle de simulation (g_ist_11, ..., g_ist_20), resp. épaisseur de couche de consigne de simulation (g_soll_11, ..., g_soll_20), une limitation lors de la variation (S104, S106) étant prédéfinie pour la couche individuelle respective (11, 12, 13, 14, 15, 16, 17, 18, 19, 20) d'une ou plusieurs couches individuelles (11, 12, 13, 14, 15, 16, 17, 18, 19, 20) qui a manqué le critère, et

mise à disposition d'une deuxième épaisseur de couche réelle de simulation (g_ist_11, ..., g_ist_20), respectivement d'une épaisseur de couche de consigne de simulation (g_soll_11, ..., g_soll_20) de la couche individuelle respective (11, 12, 13, 14, 15, 16, 17, 18, 19, 20) des une ou plusieurs couches individuelles (11, 12, 13, 14, 15, 16, 17, 18, 19, 20).

7. Système selon l'une quelconque des revendications 5 à 6, dans lequel le système est configuré pour

Répéter les étapes (S104, S106, S112, S113, S114, S115) dans un ou plusieurs autres intervalles spectraux (84, 86), chaque intervalle suivant (84, 86) incluant l'intervalle précédent (82, 84), la deuxième épaisseur de couche réelle de simulation (g_ist_11, ..., g_ist_20), respectivement. épaisseur de couche de consigne de simulation (g_soll_11, ..., g_soll_20) de la couche individuelle respective (11, 12, 13, 14, 15, 16, 17, 18, 19, 20) de l'intervalle précédent (82, 84) sont utilisées dans l'intervalle suivant (84, 86) comme valeurs de départ et

mise à disposition d'une épaisseur de couche réelle de simulation finale (g_ist_11, ..., g_ist_20), respectivement d'une épaisseur de couche de consigne de simulation (g_soll_11, ..., g_soll_20) de la couche individuelle respective (11, 12, 13, 14, 15, 16, 17, 18, 19, 20) d'une ou de plusieurs couches individuelles (11, 12, 13, 14, 15, 16, 17, 18, 19, 20).

8. Système selon l'une des revendications 1 à 7, dans lequel le système est conçu de telle sorte qu'un système de couches (10) réduisant les réflexions interférométriques est déposé sur au moins une surface (24) d'un substrat (22),

le système de couches (10) comprenant une pile (40) d'au moins quatre paquets de couches successifs (42, 44, 46, 48, 50), chaque paquet de couches (42, 44, 46, 48, 50) comprenant une paire de premières et secondes couches individuelles (11, 12, 13, 14, 15, 16, 17, 18, 19, 20), les premières couches individuelles (11, 13, 15, 17, 19) ayant une première épaisseur optique (t1) et les secondes couches individuelles (12, 14, 16, 18, 20) ayant une seconde épaisseur optique (t2) différente de la première épaisseur optique (t1),

un indice de réfraction (n1) des premières couches individuelles (11, 13, 15, 17, 19) respectivement plus proches du substrat étant supérieur à un indice de réfraction (n2) des secondes couches individuelles (12, 14, 16, 18, 20) respectivement plus éloignées du substrat de l'empilement (40),

le système de couches (10) présentant une luminosité (L*), une chromaticité (C*) et un angle de chromaticité (h) d'une couleur de réflexion résiduelle,

la valeur absolue d'une variation (Δh) de l'angle de teinte (h) de la couleur réfléchie résiduelle dans un intervalle d'un angle d'observation (AOI) ayant les valeurs limites 0° et 30° par rapport à une normale à la surface (70) sur le système de couches (10) étant inférieure à la valeur absolue d'une variation (ΔC*) de la chromaticité (C*) dans l'intervalle de l'angle d'observation (AOI), les étapes suivantes étant effectuées :

- Définir une conception de couche comprenant au moins un premier matériau pour des premières couches individuelles à haute réfraction (11, 13, 15, 17, 19) et un deuxième matériau pour des deuxièmes couches individuelles à faible réfraction (12, 14, 16, 18, 20), le nombre de paquets de couches souhaités (42, 44, 46, 48, 50) avec les couches individuelles (11, 12, 13, 14, 15, 16, 17, 18, 19, 20), les valeurs de départ de l'épaisseur des couches individuelles (11, 12, 13, 14, 15, 16, 17, 18, 19, 20) ;
- définir des valeurs de couleur cibles, comprenant la luminosité (L*), la chromaticité (C*) et l'angle de teinte (h), au moins à des valeurs limites pour un intervalle d'un angle d'observation (AOI) ayant des valeurs limites de 0° et 30°;
- mise en œuvre d'un processus d'optimisation pour faire varier les épaisseurs des couches individuelles (d_ist_11, ..., d_ist_20) jusqu'à ce qu'un objectif d'optimisation soit atteint.

9. Système selon la revendication 8,

le système étant conçu pour que l'angle de teinte (h) dans l'intervalle de l'angle d'observation (AOI) avec les valeurs limites 0° et 30° varie de 15° au maximum, de préférence de 10° au maximum ;
et/ou
le système étant conçu pour , que la valeur de la variation ($\Delta$h) de l'angle de tonalité (h) dans un deuxième intervalle d'un angle d'observation (AOI) de 0° jusqu'à un angle d'observation limite ($\Theta$) ayant une valeur limite supérieure comprise entre 30° et 45° par rapport à la normale à la surface (70) sur le système de couches (10) est inférieure à la valeur d'un changement ($\Delta$C*) de la coloration (C*) dans le deuxième intervalle de l'angle d'observation (AOI) et la valeur de la coloration (C*) à l'angle d'observation limite ($\Theta$) est d'au moins 2, en particulier, l'angle de chromaticité (h) dans le deuxième intervalle changeant au plus de 20°, de préférence au plus de 15° ;
et/ou
le système étant conçu pour que la réflectance photopique (Rv) dans l'intervalle de l'angle d'observation (AOI) ayant les valeurs limites 0° et 30° soit au plus de 1,5%, de préférence au plus de 1,2% ;
et/ou
le système étant conçu de telle sorte que la réflectance scotopique (Rv') dans l'intervalle de l'angle d'observation (AOI) avec les valeurs limites 0° et 30° soit au plus de 1,5%, de préférence au plus de 1,2%.

10. Procédé de fabrication d'un système de couches (10) dans au moins une installation de revêtement (108) avec un procédé dans un système (200) selon l'une des revendications précédentes, dans lequel le système de couches (10) est fabriqué sur la base d'un ensemble de données de consigne de simulation finale (DAT_soll_sim) pour l'installation de revêtement (108).

11. Installation de revêtement (108) pour la fabrication d'un système de couches (10), avec un procédé dans un système (200) selon au moins la revendication 1,
comprenant au moins l'un des éléments suivants

  (i) un composant (116) pour appliquer un processus de vieillissement artificiel au système de couches (10),
  (ii) un appareil de mesure optique (118) pour déterminer une courbe de mesure réelle (90) à résolution spectrale du système de couches (10).

12. Produit programme informatique pour un procédé d'exploitation d'au moins une installation de revêtement (108) pour la fabrication de systèmes de couches (10), le produit programme informatique comprenant au moins un support de mémoire lisible par ordinateur, qui comprend des instructions de programme qui sont exécutables sur un système informatique (102) et qui amènent le système informatique (102) à exécuter un procédé dans un système (100) selon au moins la revendication 1.

Fig. 1

Fig. 2

Fig. 3

Fig. 4

Fig. 5

Fig. 6

Fig. 7

Fig. 8

Fig. 9

Fig. 10

EP 4 451 039 B1

Fig. 11

40

Fig. 12

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2016110339 A1
- US 2015021168 A1

- EP 3346023 A1

**In der Beschreibung aufgeführte Nicht-Patentliteratur**

- **V. A. KHERAJ et al.** Simulation of reflectivity spectrum for non-absorbing multilayer optical films. *Pramana*, 01 June 2009, vol. 72 (6), ISSN 0304-4289, 1011-1022